# EUROPEAN PATENT APPLICATION

(11) **EP 4 138 256 A1**
(43) Date of publication of application: **22.02.2023**
(21) Application number: 21828091.5
(22) Date of filing: 30.04.2021
(51) Int. Cl.: H02J 7/00

(54) **POWER ADAPTER AND ELECTRONIC DECIVE ASSEMBLY**

(30) Priority: 22.06.2020 CN 202010576024
(71) Applicant: GUANGDONG OPPO MOBILE TELECOMMUNICATIONS CORP., LTD., Dongguan, Guangdong 523860 (CN)
(72) Inventor: ZHAO, Bin, Dongguan, Guangdong 523860 (CN); ZUO, Zhouquan, Dongguan, Guangdong 523860 (CN); CAI, Hongzhen, Dongguan, Guangdong 523860 (CN)
(74) Representative: Mewburn Ellis LLP
(86) International application number: PCT/CN2021/091598
(87) International publication number: WO 2021/258859

(57) **Abstract**

Power adapters and an electronic device assembly including a power adapter are provided in the disclosure. The power adapter includes an adapter body, prongs, and a cover. The prongs are exposed at an end surface of the adapter body. The cover is connected to the adapter body, rotatable relative to the adapter body, and has an accommodation cavity corresponding to the prongs. When the cover is closed, the accommodation cavity of the cover accommodates the prongs; and when the cover is opened, a surface of the cover facing the prongs and the end surface of the adapter body cooperatively form a plug surface of the power adapter. The accommodation cavity of the cover of the power adapter in the disclosure can accommodate the prongs, and thus the prongs can be protected from being damaged and other objects can be prevented from being damaged by the prongs. Additionally, the surface of the cover facing the prongs and the end surface of the adapter body cooperatively form the plug surface of the power adapter. Therefore, the adapter body can be made relatively thin, which is conductive to the miniaturization of the power adapter.

## Description

### TECHNICAL FIELD

This disclosure relates to the field of electronic technology, and particularly to a power adapter and an electronic device assembly.

### BACKGROUND

With the progress of technologies, electronic devices such as mobile phones have become necessities of life. Power adapters are generally used to charge electronic devices such as mobile phones.

An existing power adapter generally includes an adapter body and prongs exposed outside the adapter body. However, since the prongs of the existing power adapter are exposed entirely, the prongs are easy to be damaged.

### SUMMARY

A power adapter is provided in the disclosure. The power adapter includes an adapter body, prongs, and a cover. The prongs are exposed at an end surface of the adapter body. The cover is connected to the adapter body, rotatable relative to the adapter body, and has an accommodation cavity corresponding to the prongs. When the cover is closed, the accommodation cavity of the cover accommodates the prongs; and when the cover is opened, a surface of the cover facing the prongs and the end surface of the adapter body cooperatively form a plug surface of the power adapter.

A power adapter is further provided in the disclosure. The power adapter includes an adapter body, prongs, a first cover, and a second cover. The adapter body has a first end-surface where the prongs are exposed, the second cover has a second end-surface, and the second cover has a third end-surface. The first cover and the second cover are both rotationally connected to the adapter body. When the first cover and the second cover are buckled, the first cover and the second cover are located at the same side of the first end-surface, and the second end-surface and the third end-surface face the first end-surface; and when the first cover and the second cover are opened relatively, the first cover and the second cover are stacked respectively at two opposite sides of the adapter body, and the first end-surface, the second end-surface, and the third end-surface cooperatively form a plug surface of the power adapter.

A power adapter is further provided in the disclosure. The power adapter includes an adapter body, prongs, a first cover, and a second cover. The prongs are connected to the adapter body. The first cover and the second cover are both rotationally connected to the adapter body. The first cover and the second cover cooperate with each other to cover or expose the prongs. A thickness D1 of the adapter body fulfills 6.3 mm≤D1≤14 mm. An end surface of the adapter body where the prongs are exposed forms part of a plug surface where the power adapter is plugged into a socket.

An electronic device assembly is further provided in the disclosure. The electronic device assembly includes an electronic device and the power adapter mentioned above. The power adapter is configured to charge the electronic device.

### BRIEF DESCRIPTION OF THE DRAWINGS

In order to describe technical solutions in implementations of the disclosure more clearly, the following will give a brief introduction of accompanying drawings used in the implementations. Apparently, the accompanying drawings described below are some implementations of the disclosure. Those of ordinary skill in the art can further obtain other accompanying drawings based on the accompanying drawings without creative efforts.
FIG. 1 is a schematic diagram of an application environment of a power adapter provided in an implementation of the disclosure.
FIG. 2 is a schematic view of a power adapter in a state provided in an implementation of the disclosure.
FIG. 3 is a schematic view of a power adapter in another state provided in an implementation of the disclosure.
FIG. 4 is a schematic view of a power adapter in a state provided in an implementation of the disclosure.
FIG. 5 is an exploded perspective view of a power adapter provided in an implementation of the disclosure.
FIG. 6 is a bottom view of an adapter body and a second cover of the power adapter illustrated in FIG. 5.
FIG. 7 is a schematic diagram of an assembling method of a power adapter provided in an implementation of the disclosure.
FIG. 8 is a schematic structural view of a power adapter after S110.
FIG. 9 is a sectional view of the power adapter illustrated in FIG. 8, taken along line I-I.
FIG. 10 is a schematic structural view of a power adapter after S 120.
FIG. 11 is a sectional view of the power adapter illustrated in FIG. 10, taken along line II-II.
FIG. 12 is a schematic structural view of a power adapter after S130.
FIG. 13 is a sectional view of the power adapter illustrated in FIG. 12, taken along line III-III.
FIG. 14 is a schematic structural view of a power adapter after S 140.
FIG. 15 is a sectional view of the power adapter illustrated in FIG. 14, taken along line IV-IV
FIG. 16 is an exploded perspective view of a power adapter provided in an implementation of the disclosure.
FIG. 17 is a rear view of the power adapter illustrated in FIG. 16 after assembling.
FIG. 18 is a sectional view of the power adapter illustrated in FIG. 17, taken along line B-B.
FIG. 19 is a schematic diagram of an assembling method of a power adapter provided in another implementation of the disclosure.
FIG. 20 is a schematic structural view of a power adapter after S210.
FIG. 21 is a sectional view of the power adapter illustrated in FIG. 20, taken along line a-a.
FIG. 22 is a schematic structural view of a power adapter after S220.
FIG. 23 is a sectional view of the power adapter illustrated in FIG. 22, taken along line b-b.
FIG. 24 is a schematic structural view of a power adapter after S230.
FIG. 25 is a sectional view of the power adapter illustrated in FIG. 24, taken along line c-c.
FIG. 26 is a schematic structural view of the power adapter after S230.
FIG. 27 is a sectional view of the power adapter illustrated in FIG. 26, taken along line d-d.
FIG. 28 is a front view of a power adapter provided in an implementation of the disclosure.
FIG. 29 is a rear view of the power adapter illustrated in FIG. 28.
FIG. 30 is a side view of the power adapter illustrated in FIG. 28, viewed from an angle.
FIG. 31 is a side view of the power adapter illustrated in FIG. 28, viewed from another angle.
FIG. 32 is a top view of the power adapter illustrated in FIG. 28.
FIG. 33 is a bottom view of the power adapter illustrated in FIG. 28.
FIG. 34 is a schematic view of a power adapter in a state provided in another implementation of the disclosure.
FIG. 35 is a schematic view of a power adapter in another state provided in an implementation of the disclosure.
FIG. 36 is a schematic structural view of the power adapter without the first cover illustrated in FIG. 35.
FIG. 37 is a sectional view of the power adapter illustrated in FIG. 34, taken along line P-P.
FIG. 38 is an enlarged schematic view of portion Q in FIG. 37.
FIG. 39 is an assembly view of a first rotatable member provided in an implementation of the disclosure.
FIG. 40 is a schematic view illustrating a position of the first rotatable member in a power adapter.
FIG. 41 is an exploded perspective view of a first rotatable member provided in an implementation of the disclosure.
FIG. 42 is a schematic view of a first box in the first rotatable member provided in FIG. 39.
FIG. 43 is a schematic view of a first box-cover in the first rotatable member provided in FIG. 39.
FIG. 44 is a schematic view of a first rotatable portion in the first rotatable member provided in FIG. 39.
FIG. 45 is a schematic view of a power adapter in a state.
FIG. 46 is a sectional view of the first rotatable member illustrated in FIG. 39, taken along line XI-XI, when the power adapter is in the state illustrated in FIG. 45.
FIG. 47 is a schematic view of a power adapter in another state.
FIG. 48 is a schematic view of a first rotatable member when the power adapter is in the state illustrated in FIG. 47.
FIG. 49 is a schematic view of a power adapter in another state.
FIG. 50 is a schematic view of a first rotatable member when the power adapter is in the state illustrated in FIG. 49.
FIG. 51 is a schematic view of a power adapter in another state.
FIG. 52 is a schematic view of a first rotatable member when the power adapter is in the state illustrated in FIG. 51.
FIG. 53 is an enlarged schematic view of portion XII in FIG. 46.
FIG. 54 is an enlarged schematic view of portion XIII in FIG. 52.
FIG. 55 is an assembly view of a first rotatable member provided in yet another implementation of the disclosure, viewed from an angle.
FIG. 56 is an assembly view of the first rotatable member provided in FIG. 55, viewed from another angle.
FIG. 57 is a schematic view illustrating the first rotatable member provided in FIG. 56 being applied to a power adapter.
FIG. 58 is an enlarged schematic view of portion C in FIG. 57.
FIG. 59 is a perspective structural view of a power adapter provided in another implementation of the disclosure.
FIG. 60 is a sectional view of the power adapter illustrated in FIG. 59, taken along line XIV-XIV.
FIG. 61 is a schematic view of a power adapter in a state provided in an implementation of the disclosure.
FIG. 62 is a schematic view of a power adapter in another state provided in an implementation of the disclosure.
FIG. 63 is a perspective schematic view of a power adapter in a state provided in another implementation of the disclosure.
FIG. 64 is a perspective schematic view of the power adapter provided in FIG. 63 in another state in an implementation.
FIG. 65 is a side view of the power adapter illustrated in FIG. 64 in an implementation.
FIG. 66 is a perspective schematic view of the power adapter provided in FIG. 63 in another state in an implementation.
FIG. 67 is a schematic diagram of an electronic device assembly provided in an implementation of the disclosure.

### DETAILED DESCRIPTION

In a first aspect, a power adapter is provided in implementations of the disclosure. The power adapter includes an adapter body, prongs, and a cover. The prongs are exposed at an end surface of the adapter body. The cover is connected to the adapter body, rotatable relative to the adapter body, and has an accommodation cavity corresponding to the prongs. When the cover is closed, the accommodation cavity of the cover accommodates the prongs; and when the cover is opened, a surface of the cover facing the prongs and the end surface of the adapter body cooperatively form a plug surface of the power adapter.

The cover includes a first cover and a second cover. The first cover is connected to the adapter body and rotatable relative to the adapter body. The second cover is connected to the adapter body and rotatable relative to the adapter body. When the first cover and the second cover are buckled, the first cover and the second cover cooperatively cover the prongs; when the first cover and the second cover are opened relatively, the prongs are exposed. A surface of the first cover facing the prongs, a surface of the second cover facing the prongs, and the end surface of the adapter body cooperatively form the plug surface of the power adapter.

The power adapter further includes a first rotatable member and a second rotatable member. One end of the first rotatable member is connected to the first cover, and the other end of the first rotatable member is connected to the adapter body, such that the first cover is rotationally connected to the adapter body. One end of the second rotatable member is connected to the second cover, and the other end of the second rotatable member is connected to the adapter body, such that the second cover is rotationally connected to the adapter body.

The first rotatable member is a first flexible membrane, and the first flexible membrane is attached to an outer surface of the adapter body and an outer surface of the first cover. The second rotatable member is a second flexible membrane, and the second flexible membrane is attached to the outer surface of the adapter body and an outer surface of the second cover.

The outer surface of the adapter body includes a first side surface and a second side surface opposite the first side surface. The first side surface defines a first groove, the first cover defines a second groove on the outer surface of the first cover, and the second groove communicates with the first groove to define a whole space to accommodate the first flexible membrane.

The first flexible membrane is made of an insulative material, and the first flexible membrane further covers a gap between the first cover and the adapter body. The second flexible membrane is made of an insulative material, and the second flexible membrane further covers a gap between the second cover and the adapter body.

The first rotatable member includes a first fixing portion, a second fixing portion, and a first rotatable portion. The first fixing portion is fixed on the adapter body, the second fixing portion is fixed on the first cover, and the first rotatable portion is rotationally connected to the first fixing portion and the second fixing portion. The second rotatable member includes a third fixing portion, a fourth fixing portion, and a second rotatable portion. The third fixing portion is fixed on the adapter body, the fourth fixing portion is fixed on the second cover, and the second rotatable portion is rotationally connected to the third fixing portion and the fourth fixing portion.

The adapter body includes a housing and a prong base. The housing has an opening. The prong base is configured to fix the prongs, is fixed on the housing, and seals the opening. The first fixing portion and the third fixing portion are respectively fixed on the prong base.

The adapter body has an accommodation space. When the first cover and the second cover are buckled, the first rotatable member is further configured to drive the prongs to retract to the accommodation space; and when the first cover and the second cover are opened relatively, the first rotatable member is further configured to drive the prongs to extend out of the accommodation space.

The first rotatable member includes a first rotatable sub-member, and the second rotatable member includes a second rotatable sub-member. The first rotatable sub-member and the second rotatable sub-member are arranged in the adapter body at intervals, and the first rotatable sub-member and the second rotatable sub-member are respectively connected to two opposite sides of the prongs. When the first cover and the second cover are buckled, the first rotatable sub-member and the second rotatable sub-member cooperate with each other to drive the prongs to retract to the accommodation space; and when the first cover and the second cover are opened relatively, the first rotatable sub-member and the second transmission sub-member cooperate with each other to drive the prongs to extend out of the accommodation space.

The first rotatable sub-member includes a transmission gear and a rack, and the second rotatable sub-member includes a transmission gear and a rack. The transmission gear of the first rotatable sub-member and the transmission gear of the second rotatable sub-member are rotationally connected to the adapter body, and the rack of the first rotatable sub-member and the rack of the second rotatable sub-member are configured to fix the prongs. The rack of the first rotatable sub-member is driven to rotate by the gear of the first rotatable sub-member, and the rack of the second rotatable sub-member is driven to rotate by the gear of the second rotatable sub-member, such that the prongs are driven to retract to or extend out of the accommodation space.

The first fixing portion includes a first box and a first box-cover, and the second fixing portion includes a second box and a second box-cover. The first box, the first box-cover, the second box, and the second box-cover cooperatively define a receiving space, and the receiving space is used to accommodate the first rotatable portion. The first rotatable portion is rotationally connected to the first box, the first box-cover, the second box, and the second box-cover.

The first box includes a first mating portion, and the first box-cover includes a second mating portion. The first rotatable portion includes a third mating portion and a fourth mating portion. The third mating portion cooperates with the first mating portion and the fourth mating portion cooperates with the second mating portion, such that the first rotatable portion is rotatable relative to the first box and the first box-cover.

The first box further includes a fifth mating portion, the first box-cover further includes a sixth mating portion, and the first rotatable portion includes a seventh mating portion and an eighth mating portion. The seventh mating portion cooperates with the fifth mating portion and the eighth mating portion cooperates with the sixth mating portion, so as to relieve shaking of the first cover when the first cover is fixed relative to the adapter body and improve smoothness of rotation of the first cover relative to the adapter body.

The first mating portion is a curved through hole, and the second mating portion is a curved through hole. The fifth mating portion is a groove, and the sixth mating portion is a groove. The fifth mating portion communicates with the first mating portion, and the sixth mating portion communicates with the second mating portion. The seventh mating portion has an elliptical cross section, and the eighth mating portion has an elliptical cross section. When the first cover is fixed relative to the adapter body, a gap between the seventh mating portion and the fifth mating portion is d1, and when the first cover rotates relative to the adapter body, the gap between the seventh mating portion and the fifth mating portion is d2, and d1<d2. When the first cover is fixed relative to the adapter body, a gap between the eighth mating portion and the sixth mating portion is d3, and when the first cover rotates relative to the adapter body, the gap between the eighth mating portion and the sixth mating portion is d4, and d3<d4.

The power adapter further includes a first magnetic member and a second magnetic member, where the first magnetic member is carried on the first cover, and the second magnetic member is carried on the second cover. The first magnetic member and the second magnetic member are attracted to each other when the first cover and the second cover are buckled, and the first magnetic member and the second magnetic member are attracted to each other when the first cover and the second cover are opened relatively, such that the first cover and the second cover are fixed respectively at two opposite sides of the adapter body.

The first magnetic member includes a first magnetic pole and a second magnetic pole which are arranged opposite each other and have opposite polarities, and the second magnetic member includes a third magnetic pole and a fourth magnetic pole which are arranged opposite each other and have opposite polarities. The first magnetic pole and the third magnetic pole are attracted to each other when the first cover and the second cover are buckled, and the second magnetic pole and the fourth magnetic pole are attracted to each other when the first cover and the second cover are opened relatively.

A thickness D1 of the adapter body fulfills 6.3 mm≤D1≤14 mm.

A thickness D2 of the first cover fulfills 4.825 mm≤D2≤7 mm, and a thickness D3 of the second cover fulfills 4.825 mm≤D3≤7 mm.

The number of the cover is one. When the cover is opened, the cover is located at one side of the adapter body, and the surface of the cover facing the prongs and the end surface of the adapter body cooperatively form the plug surface of the power adapter.

In a second aspect, a power adapter is further provided in implementations of the disclosure. The power adapter includes an adapter body, prongs, a first cover, and a second cover. The adapter body has a first end-surface where the prongs are exposed, the first cover has a second-end surface, and the second cover has a third end-surface. The first cover and the second cover are both rotationally connected to the adapter body. When the first cover and the second cover are buckled, the first cover and the second cover are located at the same side of the first end-surface to cover the prongs, and the second end-surface and the third end-surface face the first end-surface; and when the first cover and the second cover are opened relatively, the first cover and the second cover are stacked respectively on two opposite sides of the adapter body to expose the prongs, and the first end-surface, the second end-surface, and the third end-surface cooperatively form a plug surface of the power adapter.

The adapter body has a first side surface and a second side surface opposite the first side surface. The first cover has a first surface, and the second cover has a second surface. When the first cover and the second cover are buckled, the first surface is coplanar with the first side surface, and the second surface is coplanar with the second side surface; and when the first cover and the second cover are opened relatively, the first surface faces the first side surface, and the second surface faces the second side surface.

The power adapter further includes a first flexible membrane and a second flexible membrane. The first flexible membrane is attached to the first side surface and the first surface, such that the first cover is rotationally connected to the adapter body. The second flexible membrane is attached to the second side surface and the second surface, such that the second cover is rotationally connected to the adapter body.

The power adapter further includes a first rotatable member and a second rotatable member. The first rotatable member includes a first fixing portion, a second fixing portion, and a first rotatable portion. The first fixing portion is fixed on the adapter body, the second fixing portion is fixed on the first cover, and the first rotatable portion is rotationally connected to the first fixing portion and the second fixing portion. The second rotatable member includes a third fixing portion, a fourth fixing portion, and a second rotatable portion. The third fixing portion is fixed on the adapter body, the fourth fixing portion is fixed on the second cover, and the second rotatable portion is rotationally connected to the third fixing portion and the fourth fixing portion.

The adapter body has an accommodation space, and the power adapter further includes a first transmission member and a second transmission member. When the first cover and the second cover are both folded relative to the adapter body, the first transmission member and the second transmission member cooperate with each other to drive the prongs to extend out of the accommodation space. When the first cover and the second cover are both expanded relative to the adapter body, the first transmission member and the second transmission member cooperate with each other to drive the prongs to retract to the accommodation space.

The first fixing portion includes a first box and a first box-cover, and the second fixing portion includes a second box and a second box-cover. The first box, the first box-cover, the second box, and the second box-cover cooperatively define a receiving space. The receiving space is used to accommodate the first rotatable portion. The first rotatable portion is rotationally connected to the first box, the first box-cover, the second box, and the second box-cover.

The power adapter further includes a first magnetic member and a second magnetic member, where the first magnetic member is disposed in the first cover, the second magnetic member is disposed in the second cover. The first magnetic member and the second magnetic member are attracted to each other when the first cover and the second cover are both expanded relative to the adapter body, the first magnetic member and the second magnetic member are attracted to each other when the first cover and the second cover are both folded relative to the adapter body, such that the first cover and the second cover are fixed respectively at two opposite sides of the adapter body.

A thickness D1 of the adapter body fulfills 6.3 mm≤D1≤14 mm, a thickness D2 of the first cover fulfills 4.825 mm≤D2≤7 mm, and a thickness D3 of the second cover fulfills 4.825 mm≤D3≤7 mm.

In a third aspect, a power adapter is further provided in implementations of the disclosure. The power adapter includes an adapter body, prongs, a first cover, and a second cover. The prongs are connected to the adapter body. The first cover and the second cover are both rotationally connected to the adapter body. The first cover and the second cover cooperate with each other to cover or expose the prongs. A thickness D1 of the adapter body fulfills 6.3 mm≤D1≤14 mm. An end surface of the adapter body where the prongs are exposed forms part of a plug surface where the power adapter is plugged into a socket.

Part of an end surface of the first cover and part of an end surface of the second cover further form part of the plug surface, and a width D of the plug surface fulfills 19.3 mm≤D≤28 mm.

The first cover and the second cover are stacked respectively on two opposite sides of the adapter body. A thickness D2 of the first cover fulfills 4.825 mm≤D2≤7 mm, and a thickness D3 of the second cover fulfills 4.825 mm≤d3≤7 mm. The adapter body, the first cover, and the second cover cooperatively form the plug surface.

In a fourth aspect, an electronic device assembly is further provided in implementations of the disclosure. The electronic device assembly includes an electronic device and the power adapter described in the first aspect, the second aspect, the third aspect, and each implementation of the first aspect, the second aspect, and the third aspect. The power adapter is configured to charge the electronic device.

The following will clearly and completely describe technical solutions of the implementations of the disclosure with reference to the accompanying drawings used herein. Apparently, the implementations described herein are merely some implementations, rather than all implementations, of the disclosure. Based on the implementations described herein, all other implementations obtained by those of ordinary skill in the art without creative effort shall fall within the protection scope of the disclosure.

The term "embodiment" or "implementation" referred to herein means that a particular feature, structure, or characteristic described in conjunction with embodiments or implementations may be included in at least one embodiment of the disclosure. The phrase appearing in various places in the specification does not necessarily refer to the same embodiment, nor is it an independent or alternative embodiment mutually exclusive with other embodiments. Those skilled in the art explicitly and implicitly understand that the embodiments described herein can be combined with other embodiments.

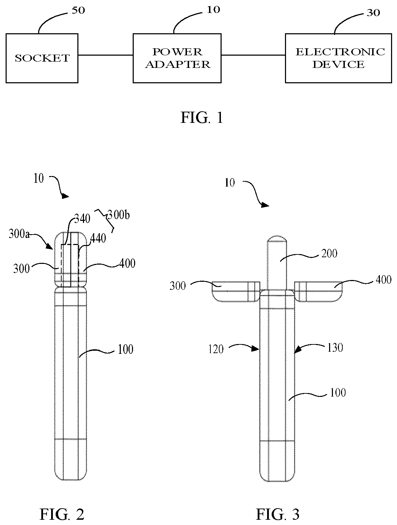

A power adapter 10 is provided in the disclosure. Referring to FIG. 1, FIG. 1 is a schematic diagram of an application environment of a power adapter provided in an implementation of the disclosure. The power adapter 10 is a power supply converter for the electronic device 30. Generally, the power adapter 10 can convert an alternating current voltage into a direct current voltage. For example, the power adapter 10 is plugged into a socket 50 to receive an alternating current voltage outputted by the socket 50 and convert the alternating current voltage received into a direct current voltage. The direct current voltage is used to charge an electronic device 30, such as a mobile phone, a computer, etc. It can be understood that, the schematic diagram of the application environment of the power adapter 10 only helps to understand the application of the power adapter 10 and should not be considered as a limitation on the power adapter 10 provided in the disclosure.

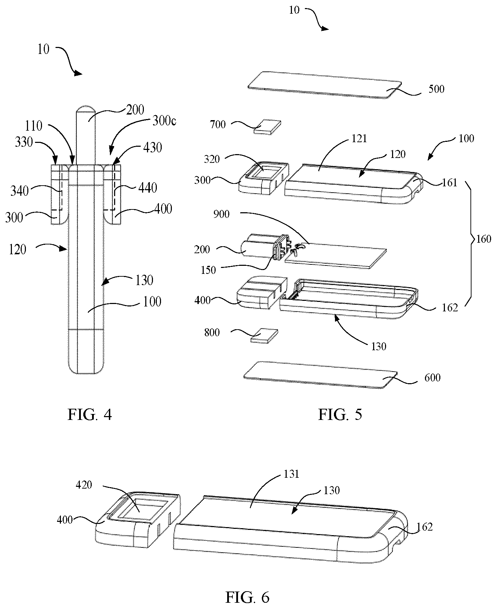

Referring to FIG. 2, FIG. 3, and FIG. 4 together, FIG. 2 is a schematic view of a power adapter in a state provided in an implementation of the disclosure, FIG. 3 is a schematic view of a power adapter in another state provided in an implementation of the disclosure, and FIG. 4 is a schematic view of a power adapter in a state provided in an implementation of the disclosure.

The power adapter 10 includes an adapter body 100, prongs 200, and a cover 300a. The prongs 200 are exposed at an end surface 110 of the adapter body 100. The cover 300a is connected to the adapter body 100 and rotatable relative to the adapter body 100. The cover 300a has an accommodation cavity 300b corresponding to the prongs 200. When the cover 300a is closed, the accommodation cavity 300b of the cover 300a accommodates the prongs 200. When the cover 300a is opened, a surface 300c of the cover 300a facing the prongs 200 and the end surface 110 of the adapter body 100 cooperatively form a plug surface of the power adapter 10.

In the implementation, as an example, the cover 300a includes a first cover 300 and a second cover 400. In other words, the power adapter 10 includes the adapter body 100, the prongs 200, the first cover 300, and the second cover 400. The prongs 200 are connected to the adapter body 100. The first cover 300 is rotationally connected to the adapter body 100 and the second cover 400 is rotationally connected to the adapter body 100. When the first cover 300 and the second cover 400 are buckled, the prongs 200 are covered. When the first cover 300 and the second cover 400 are opened relatively, the prongs 200 are exposed.

It should be noted that, the terms "first", "second", etc. used in the specification, the claims, and the accompany drawings of the disclosure are used to distinguish different objects rather than describe a particular order. In addition, the terms "comprise" and "have" as well as variations thereof are intended to cover non-exclusive inclusion.

The adapter body 100 refers to part of the power adapter 10 that realizes a voltage conversion function of the power adapter 10. The adapter body 100 generally includes a circuit board for voltage conversion. In addition, the adapter body 100 may further include a housing for accommodating the circuit board and other components.

The prongs 200 are made of metal. The prongs 200 are plugged into the socket 50 for receiving the alternating current voltage provided by the socket 50. The number of the prongs 200 may be but is not limited to two. The number of the prongs 200 is two in the disclosure. The two prongs 200 are disposed oppositely and at intervals. The prongs 200 may be in the shape of a long strip, which is not limited herein. An end of the prong 200 away from the body of the socket 50 is curved, such that the prongs 200 can be plugged into the socket 50. When the prongs 200 are plugged into the socket 50 to receive a first voltage, the circuit board 900 is electrically connected to the prongs 200 to receive the first voltage transmitted from the prongs 200, and the circuit board 900 is configured to convert the first voltage into a second voltage.

The first cover 300 is rotationally connected to the adapter body 100, and the second cover 400 is rotationally connected to the adapter body 100. A manner in which the first cover 300 is rotationally connected to the adapter body 100 and a manner in which the second cover 400 is rotationally connected to the adapter body 100 will be described in detail later.

The power adapter 10 has a first state (referring to FIG. 2), a second state (referring to FIG. 4), and an intermediate state (referring to FIG. 3) between the first state and the second state. When the power adapter 10 is in the first state, the first cover 300 and the second cover 400 are buckled and completely cover the prongs 200. When the power adapter 10 is in the second state, the first cover 300 and the second cover 400 are fully opened relative to the adapter body 100, and the prongs 200 are exposed completely. When the power adapter 10 is in the third state, the first cover 300 is opened partially relative to the adapter body 100 and the second cover 400 is opened partially relative to the adapter body 100.

In an implementation, the adapter body 100 has an end surface 110, a first side surface 120, and a second side surface 130. The end surface 110 is a surface of the power adapter 10 where the prongs 200 are disposed. The first side surface 120 and the second side surface 130 are opposite to each other, both connected to the end surface 110, and both located at the same side of the end surface 110.

When the first cover 300 and the second cover 400 are buckled, the cover 300a is closed, the first cover 300 and the second cover 400 are both located at the same side of the end surface 110 to form a box, and the box is used to cover the prongs 200. When the first cover 300 and the second cover 400 are opened relatively, the cover 300a is opened, and the first cover 300 and the second cover 400 can be fixed at two opposite sides of the adapter body 100. Specifically, the first cover 300 is disposed at one side where the first side surface 120 is located, and the second cover 400 is disposed at one side where the second side surface 130 is located.

When the cover 300a includes the first cover 300 and the second cover 400, the surface 300c of the cover 300a facing the prongs 200 is formed by a surface 330 of the first cover 300 facing the prongs 200 and a surface 430 of the second cover 400 facing the prongs 200. The surface 330 of the first cover 300 facing the prongs 200, the surface 430 of the second cover 400 facing the prongs 200, and the end surface 110 of the adapter body 100 cooperatively form a plug surface of the power adapter 100. The accommodation cavity 300b is defined cooperatively by a first cavity 340 in the first cover 300 and a second cavity 440 in the second cover 400. In other implementations, the accommodation cavity 300b may also be defined only by the first cavity 340 in the first cover 300 or defined only by the second cavity 440 in the second cover 400.

The plug surface of the power adapter 10 refers to a surface of the power adapter 10 which cooperates with the socket 50 when the prongs 200 of the power adapter 10 are plugged into the socket 50, and the plug surface meets the requirements of safety regulations of the power adapter 10. When the prongs 200 of the power adapter 10 are plugged into the socket 50, a surface which cooperates with the socket 50 only but does not meet the safety regulations of the power adapter 10 cannot be regarded as the plug surface of the power adapter 10. Specifically, for the power adapter 10, when the prongs 200 of the power adapter 10 are plugged into the socket 50, in order to avoid the harm to users caused by the leakage of the electrical energy of the socket 50 through the prongs 200, the distance between the edge of the prong 200 and the edge of the plug surface nearest to the prong 200 is required to be greater than or equal to a preset distance (also called a safety distance). For example, for the power adapter applicable to China, the preset distance is 6.5 mm. For the power adapter applicable to other countries, the distance is other values. In the schematic view of the implementation (as illustrated in FIG. 4), when the first cover 300 and the second cover 400 are opened relatively, the distance between the leftmost side of the prong 200 and the surface of the first cover 300 away from the adapter body 100 (i.e., the leftmost surface of the first cover 300) is greater than or equal to the preset distance. Similarly, the distance between the rightmost side of the prong 200 and the surface of the second cover 400 away from the adapter body 100 (i.e., the rightmost surface of the second cover 400) is greater than or equal to the preset distance.

In traditional technology, the end surface of the adapter body of the power adapter 10 where the prongs 200 are disposed forms the plug surface of the power adapter. In other words, in traditional technology, the plug surface of the power adapter 10 is formed only by the end surface of the adapter body 100 where the prongs 200 are disposed. Therefore, a thickness of the adapter body is generally relatively great. For example, in order to meet the requirements of safety regulations of the power adapter 10, a width of the plug surface of the power adapter 10 is set to 22 mm. The thickness of the adapter body 100 in the disclosure and the thickness of the adapter body in the traditional technology will be analyzed below. In traditional technology, the plug surface of the adapter body 100 is formed only by the end surface of the adapter body 100 where the prongs 200 are disposed, and thus the thickness of the adapter body 100 of the power adapter 10 is the width of the plug surface. As a result, in traditional technology, the thickness of the adapter body 100 of the power adapter 10 is 22 mm. However, for the power adapter 10 in the disclosure, the surface 300c of the cover 300a facing the prongs 200 cooperatively forms the plug surface of the power adapter 10, i.e., the sum of the thickness of the adapter body 100 and the thickness of the cover 300a is equal to 22 mm. In other words, in the disclosure, the end surface 110 of the adapter body 100 of the power adapter 10 where the prongs 200 are disposed is only part of the plug surface of the power adapter 10, thus the thickness d1 of the adapter body 100 of the power adapter 10 is necessarily less than the total width of the plug surface (22 mm in the example). It can be seen that the adapter body 100 of the power adapter 10 in the disclosure is thinner than the adapter body of the power adapter in the traditional technology.

Compared with the traditional technology, in the power adapter 10 provided herein, the cover 300a is rotationally connected to the adapter body 100. Therefore, when the cover 300a is closed, the prongs 200 can be protected from being damaged and other objects can be prevented from being damaged by the prongs 200. When the power adapter 10 needs to be used, the cover 300a is relatively opened to expose the prongs 200. Furthermore, the surface 300b of the cover 300a facing the prongs 200 and the end surface 110 of the adapter body 100 cooperatively form the plug surface of the power adapter 10. In other words, the end surface of the adapter body 100 only forms part of the plug surface of the power adapter 10 and the adapter body 100 can be made relatively thin, which is conductive to the miniaturization of the power adapter 10.

Referring to FIG. 5 and FIG. 6, FIG. 5 is an exploded perspective view of a power adapter provided in an implementation of the disclosure, and FIG. 6 is a bottom view of an adapter body and a second cover of the power adapter illustrated in FIG. 5. The power adapter 10 further includes a first rotatable member 500 and a second rotatable member 600. One end of the first rotatable member 500 is connected to the first cover 300, and the other end of the first rotatable member 500 is connected to the adapter body 100, such that the first cover 300 is rotationally connected to the adapter body 100. One end of the second rotatable member 600 is connected to the second cover 400, and the other end of the second rotatable member 600 is connected to the adapter body 100, such that the second cover 400 is rotationally connected to the adapter body 100. The first rotatable member 500 and the second rotatable member 600 have various forms, which are described in detail below.

In the implementation, the first rotatable member 500 is a first flexible membrane, and the first flexible membrane is attached to an outer surface of the adapter body 100 and an outer surface of the first cover 300. The second rotatable member 600 is a second flexible membrane, and the second flexible membrane is attached to the outer surface of the adapter body 100 and an outer surface of the second cover 400.

The material of the first flexible membrane may be but is not limited to leather, mylar, etc. The material of the second flexible membrane may be but is not limited to leather, mylar, etc. With the aid of the softness of the first flexible membrane, the first cover 300 can move relative to the adapter body 100 along a certain track, and similarly, with the aid of the softness of the second flexible membrane, the second cover 400 can also move relative to the adapter body 100 along a certain track, and thus the first cover 300 and the second cover 400 can be closed or opened.

When the outer surface of the adapter body 100 includes the first side surface 120 and the second side surface 130 opposite the first side surface 120, the first flexible membrane is attached to the first side surface 120 and the outer surface of the first cover 300, and the second flexible membrane is attached to the second side surface 130 and the outer surface of the second cover 400.

In an implementation, the adapter body 100 defines a first groove 121 on the first side surface 120, the first cover 300 defines a second groove 320 on the outer surface of the first cover 300, and the second groove 320 communicates with the first groove 121 to define a whole space. The first groove 121 and the second groove 320 are used to accommodate the first flexible membrane. The first flexible membrane may be fixed in the first groove 121 and the second groove 320 via a fixing member (like glue). Correspondingly, the adapter body 100 defines a third groove 131 on the second side surface 130, the second cover 400 defines a fourth groove 420 on an outer surface of the second cover 400, and the fourth groove 420 communicates with the third groove 131 to define a whole space. The fourth groove 420 and the third groove 131 are used to accommodate the second flexible membrane. The second flexible membrane may be fixed in the third groove 131 and the fourth groove 420 via a fixing member (like glue). The overall thickness of the power adapter 10 can be reduced by the manners of disposing the first flexible membrane and the second flexible membrane.

In the implementation, the adapter body 100 includes a first housing 161 and a second housing 162. The first housing 161 and the second housing 162 are separate and the first housing 161 is fixedly connected with the second housing 162. The first housing 161 and the second housing 162 can be fixed together by ultrasonic hot melting, etc. The first housing 161 and the second housing 162 define an accommodation space to accommodate the circuit board 900 of the adapter body 100. The first housing 161 defines the first groove 121, and the second housing 162 defines the third groove 131. In the implementation, the first housing 161 and the second housing 162 are separate and are fixed together by ultrasonic hot melting, etc. which can facilitate the assembly of the power adapter 10.

Additionally, in an implementation, the power adapter10 further includes a first magnetic member 700 and a second magnetic member 800, where the first magnetic member 700 is fixed on the first housing 161, and the second magnetic member 800 is fixed on the second housing 162. The working principles of the first magnetic member 700 and the second magnetic member 800 will be described in detail later. The adapter body 100 includes a housing 160 and a prong base 150 configured to fix the prongs 200. The housing 160 includes the first housing 161 and the second housing 162.

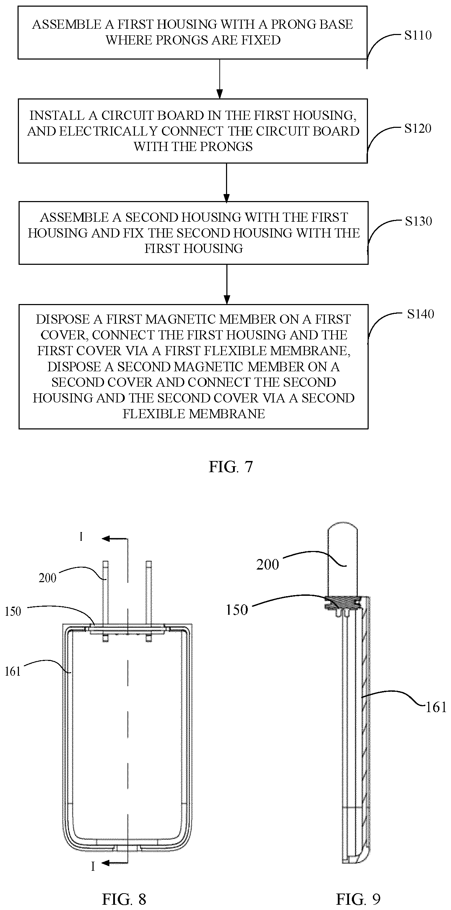

An assembling method of the power adapter 10 provided in the implementation is described as follows. Referring to FIG. 7, FIG. 7 is a schematic diagram of an assembling method of a power adapter provided in an implementation of the disclosure. The assembling method includes S110, S120, S130, and S 140 which are described in detail as follows.

At S110, assembling the first housing 161 with the prong base 150 where the prongs 200 are fixed. Referring to FIG. 8 and FIG. 9, FIG. 8 is a schematic structural view of a power adapter after S110, and FIG. 9 is a sectional view of the power adapter illustrated in FIG. 8, taken along line I-I.

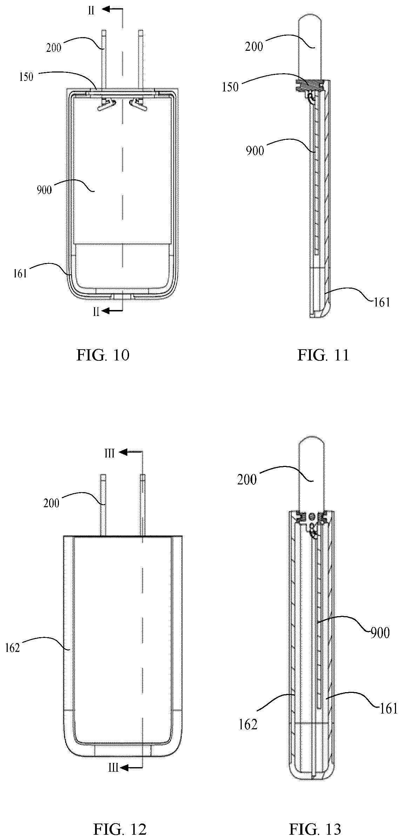

At S120, installing the circuit board 900 in the first housing 161, and electrically connecting the circuit board 900 with the prongs 200. Referring to FIG. 10 and FIG. 11, FIG. 10 is a schematic structural view of a power adapter after S 120, and FIG. 11 is a sectional view of the power adapter illustrated in FIG. 10, taken along line II-II. A manner in which the circuit board 900 is electrically connected with the prongs 200 may be, but is not limited to, wire connection.

At S130, assembling the second housing 162 with the first housing 161 and fixing the second housing 162 with the first housing 161. Referring to FIG. 12 and FIG. 13, FIG. 12 is a schematic structural view of a power adapter after S130, and FIG. 13 is a sectional view of the power adapter illustrated in FIG. 12, taken along line III-III. The second housing 162 and the first housing 161 may be fixed by but not limited to ultrasonic hot melting. The second housing 162 is fixed with the first housing 161, and the second housing 162 and the first housing 161 clamp the prong base 150, such that the power adapter 10 can be pulled off and plugged in for a long time.

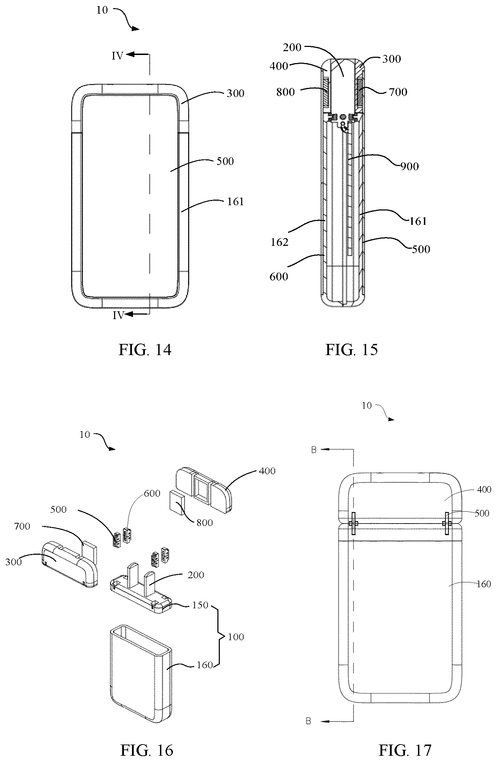

At S140, disposing the first magnetic member 700 on the first cover 300, connecting the first housing 161 and the first cover 300 via the first flexible membrane, disposing the second magnetic member 800 on the second cover 400, and connecting the second housing 162 and the second cover 400 via the second flexible membrane. Referring to FIG. 14 and FIG. 15, FIG. 14 is a schematic structural view of a power adapter after S140, and FIG. 15 is a sectional view of the power adapter illustrated in FIG. 14, taken along line IV-IV

It can be understood that, in other implementations, the first housing 161 and the second housing 162 of the adapter body 100 constitute an integrated structure to avoid a gap between the first housing 161 and the second housing 162, thus the harm to users caused by the leakage of the electrical energy through the gap can be avoided. If there is a gap between the first housing 161 and the second housing 162, the electrical energy may leak through the gap and cause harm to users. In a word, the housing 160 of the adapter body 100 is an integrated structure.

In an implementation, the first flexible membrane is made of an insulative material, and the first flexible membrane further covers a gap between the first cover 300 and the adapter body 100. The second flexible membrane is made of an insulative material, and the second flexible membrane further covers a gap between the second cover 400 and the adapter body 100.

The first flexible membrane is made of an insulative material, and the first flexible membrane further covers the gap between the first cover 300 and the adapter body 100, such that when the prongs 200 of the power adapter 10 are plugged into the socket 50, the current is prevented from leaking out through the gap between the first cover 300 and the adapter body 100, and thus the security of the power adapter 10 is improved. Similarly, the second flexible membrane is made of an insulative material, and the second flexible membrane further covers the gap between the second cover 400 and the adapter body 100, such that when the prongs 200 of the power adapter 10 are plugged into the socket 50, the current is prevented from leaking out through the gap between the second cover 400 and the adapter body 100, and thus the security of the power adapter 10 is improved.

In the above implementations, as an example, the first flexible membrane and the second flexible membrane are described as two separate flexible membranes. It can be understood that in other implementations, the first flexible membrane and the second flexible membrane are connected as an integrated structure. The first flexible membrane and the second flexible membrane constitute an integrated structure.

The power adapter 10 defines the first groove 121 on the first side surface 120, the first cover 300 defines the second groove 320 on the outer surface of the first cover 300, and the second groove 320 communicates with the first groove 121 to define a whole space. The first groove 121 and the second groove 320 are used to accommodate the first flexible membrane. The power adapter 10 defines the third groove 131 on the second side surface 130, the second cover 400 defines the fourth groove 420 on the outer surface of the second cover 400, and the fourth groove 420 communicates with the third groove 131 to define a whole space. The fourth groove 420 and the third groove 131 are used to accommodate the second flexible membrane. Furthermore, the third groove 131 further communicates with the first groove 121 to accommodate the first flexible membrane and the second flexible membrane that are in the integrated structure.

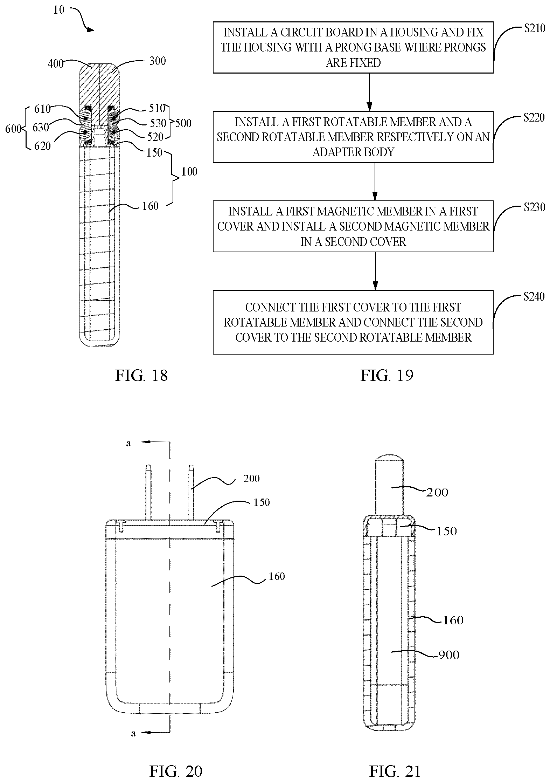

Referring to FIG. 16 to FIG. 18 together, FIG. 16 is an exploded perspective view of a power adapter provided in an implementation of the disclosure, FIG. 17 is a rear view of the power adapter illustrated in FIG. 16 after assembling, and FIG. 18 is a sectional view of the power adapter illustrated in FIG. 17, taken along line B-B. The first rotatable member 500 and the second rotatable member 600 both are shafts. In the implementation, as an example, there are two first rotatable members 500 and two second rotatable members 600. The two first rotatable members 500 are disposed at intervals, and the two second rotatable members 600 are disposed at intervals. The first rotatable member 500 includes a first fixing portion 510, a second fixing portion 520, and a first rotatable portion 530. The first fixing portion 510 is fixed on the adapter body 100, the second fixing portion 520 is fixed on the first cover 300, and the first rotatable portion 530 is rotationally connected to the first fixing portion 510 and the second fixing portion 520. The second rotatable member 600 includes a third fixing portion 610, a fourth fixing portion 620, and a second rotatable portion 630. The third fixing portion 610 is fixed on the adapter body 100, the fourth fixing portion 620 is fixed on the second cover 400, and the second rotatable portion 630 is rotationally connected to the third fixing portion 610 and the fourth fixing portion 620.

In the implementation, the first fixing portion 510 and the second fixing portion 520 both are shafts. Correspondingly, the first rotatable portion 530 defines two through holes. The first fixing portion 510 passes through one of the two through holes and is connected to the first cover 300. The second fixing portion 520 passes through the other through hole and is connected to the adapter body 100. The third fixing portion 610 and the fourth fixing portion 620 both are shafts. Correspondingly, the second rotatable portion 630 defines two through holes. The third fixing portion 610 passes through one of the two through holes and is connected to the second cover 400, and the fourth fixing portion 620 passes through the other through hole and is connected to the adapter body 100.

In an implementation, the adapter body 100 includes the housing 160 and the prong base 150. The housing 160 has an opening. The prong base 150 is configured to fix the prongs 200, is fixed on the housing 160, and seals the opening. The first fixing portion 510 and the third fixing portion 610 are respectively fixed on the prong base 150.

The prong base 150 and the prongs 200 can be fixed by in-mold decoration. In the implementation, the prong base 150 defines grooves, and the number of the grooves is equal to the sum of the number of the first rotatable members 500 and the number of the second rotatable members 600. The first fixing portion 510 and the third fixing portion 610 both are disposed in the grooves. The first cover 300 also defines grooves and the second cover 400 also defines grooves. The number of the grooves in the first cover 300 is equal to the number of the first rotatable members 500, and the number of the grooves in the second cover 400 is equal to the number of the second rotatable members 600.

The assembling method of the power adapter 10 is described as follows with reference to the power adapter 10 mentioned above. Referring to FIG. 19, FIG. 19 is a schematic diagram of an assembling method of a power adapter provided in another implementation of the disclosure. The assembling method includes S210, S220, S230, and S240 which are described in detail as follows.

At S210, installing the circuit board 900 in the housing 160 and fixing the housing 160 with the prong base 150 where the prongs 200 are fixed.

Referring to FIG. 20 and FIG. 21, FIG. 20 is a schematic structural view of a power adapter after S210, and FIG. 21 is a sectional view of the power adapter illustrated in FIG. 20, taken along line a-a. A manner in which the housing 160 is fixed with the prong base 150 may be but is not limited to ultrasonic hot melting or dispensing. The prong base 150 can abut against the circuit board 900 for positioning the prong base 150, which is conductive to fix the prong base 150 on the housing 160 subsequently. When the housing 160 and the prong base 150 are fixed by dispensing, an inner side surface of the housing 160 and a peripheral side surface of the prong base 150 are bonded by glue. Through the setting and selection of the dispensing process, there is no step surface on the adapter body 100. It can be seen that, the prong base 150 abuts against the circuit board 900, and the circuit board 900 positions the prong base 150, such that a step surface of the adapter body 100 for fixing the prong base 150 can be absent, which is conductive to the thinness and miniaturization of the power adapter 10. It can be understood that, the form of the housing 160 does not constitute limitation on the manner of fixing the housing 160 and the prong base 150. In other words, the manner of fixing the housing 160 and the prong base 150 can be applied to the housing 160 of an integrated type or split type.

At S220, installing the first rotatable member 500 and the second rotatable member 600 respectively on the adapter body 100.

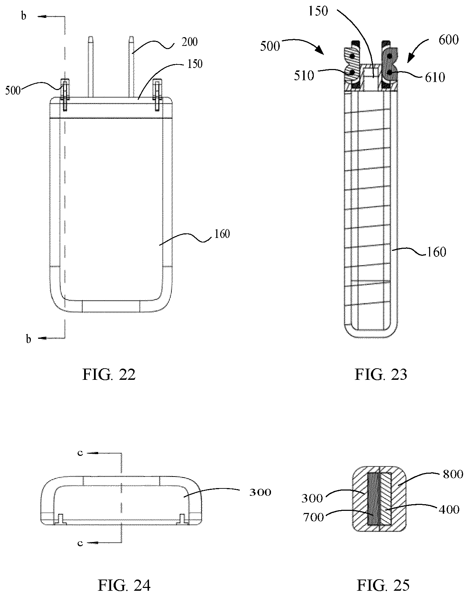

Referring to FIG. 22 and FIG. 23, FIG. 22 is a schematic structural view of a power adapter after S220, and FIG. 23 is a sectional view of the power adapter illustrated in FIG. 22, taken along line b-b. Specifically, the first fixing portion 510 of the first rotatable member 500 and the third fixing portion 610 of the second rotatable member 600 are respectively disposed in the grooves of the prong base 150 and fixed in the grooves of the prong base 150 by dispensing or other manners.

At S230, installing the first magnetic member 700 in the first cover 300 and install the second magnetic member 800 in the second cover 400.

Referring to FIG. 24 and FIG. 25, FIG. 24 is a schematic structural view of a power adapter after S230, and FIG. 25 is a sectional view of the power adapter illustrated in FIG. 24, taken along line c-c. Specifically, the first cover 300 defines a groove to install the first magnetic member 700. After the first magnetic member 700 is placed in the groove of the first cover 300, the first magnetic member 700 is fixed by dispensing or other manners. Correspondingly, the second cover 400 defines a groove to install the second magnetic member 800. After the second magnetic member 800 is placed in the groove of the second cover 400, the second magnetic member 800 is fixed by dispensing or other manners.

At S240, connecting the first cover 300 to the first rotatable member 500 and connecting the second cover 400 to the second rotatable member 600.

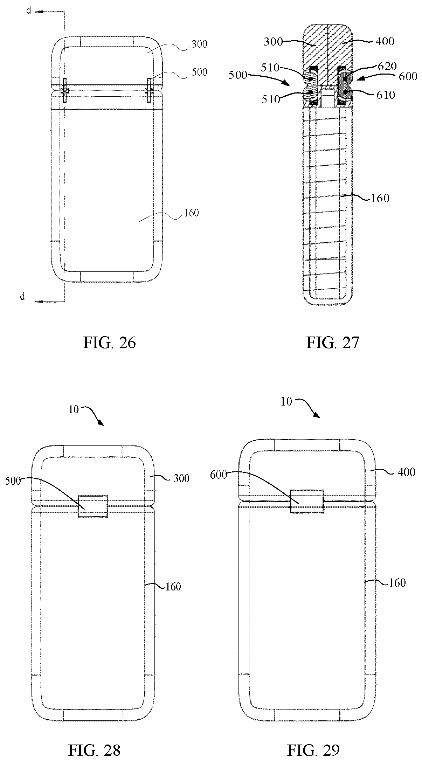

Referring to FIG. 26 and FIG. 27, FIG. 26 is a schematic structural view of a power adapter after S230, and FIG. 27 is a sectional view of the power adapter illustrated in FIG. 26, taken along line d-d. Specifically, the first cover 300 defines a groove and the second cover 400 defines a groove. The second fixing portion 520 of the first rotatable member 500 is disposed in the groove of the first cover 300 and fixed with the first cover 300. The fourth fixing portion 620 of the second rotatable member 600 is disposed in the groove of the second cover 400 and fixed with the second cover 400.

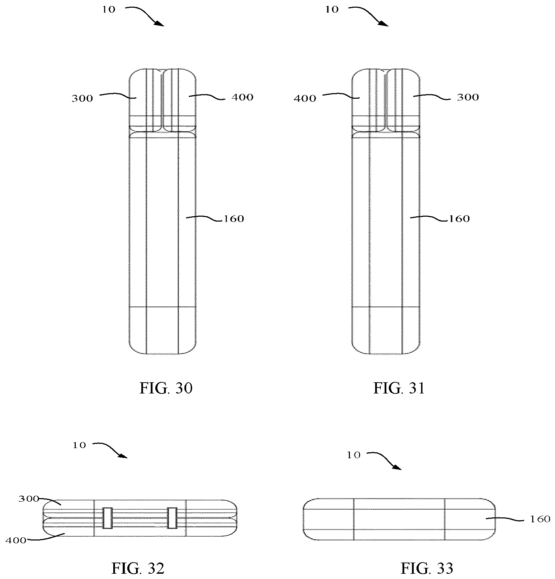

In the above implementation, as an example, there are two first rotatable members 500 and two second rotatable members 600. It can be understood that, in other implementations, there may be one first rotatable member 500 and one second connecting member. Referring to FIG. 28 to FIG. 33, FIG. 28 is a front view of a power adapter provided in an implementation of the disclosure, FIG. 29 is a rear view of the power adapter illustrated in FIG. 28, FIG. 30 is a side view of the power adapter illustrated in FIG. 28, viewed from an angle, FIG. 31 is a side view of the power adapter illustrated in FIG. 28, viewed from another angle, FIG. 32 is a top view of the power adapter illustrated in FIG. 28, and FIG. 33 is a bottom view of the power adapter illustrated in FIG. 28.

It can be understood that, there may be one or more first rotatable members 500 and one or more second rotatable members 600, and the number of the first rotatable members 500 may be equal to or not equal to the number of the second rotatable members 600.

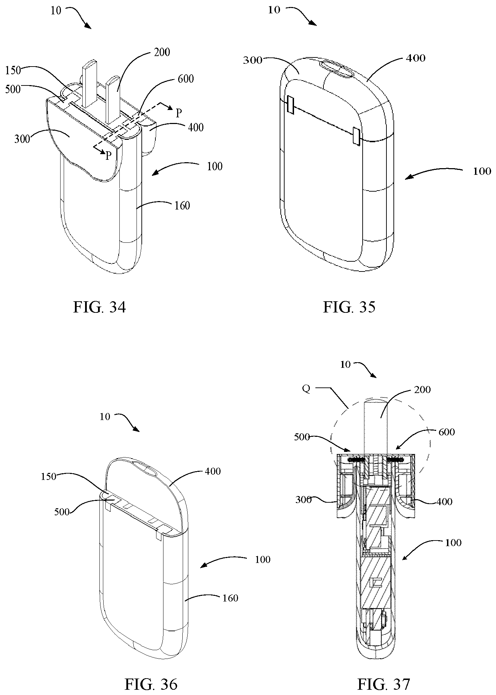

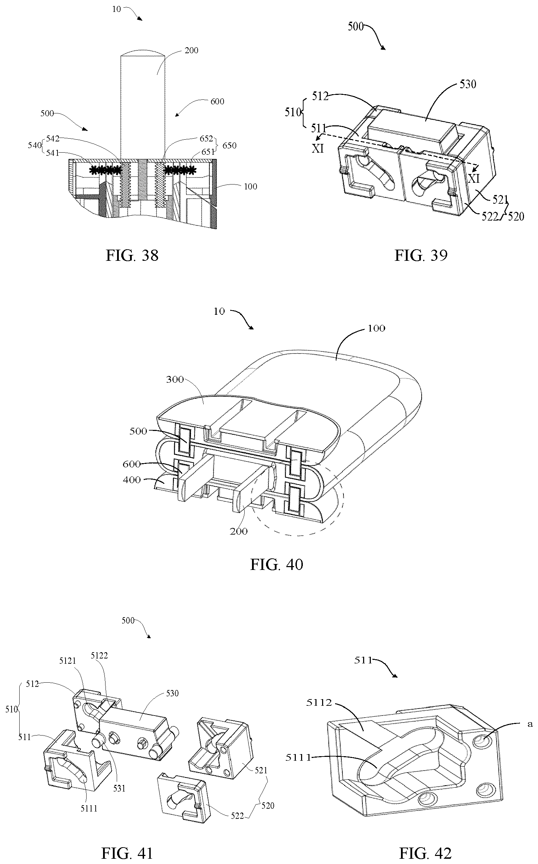

Referring to FIG. 34 to FIG. 38 together, FIG. 34 is a schematic view of a power adapter in a state provided in another implementation of the disclosure, FIG. 35 is a schematic view of a power adapter in another state provided in an implementation of the disclosure, FIG. 36 is a schematic structural view of the power adapter without the first cover illustrated in FIG. 35, FIG. 37 is a sectional view of the power adapter illustrated in FIG. 34, taken along line P-P, and FIG. 38 is an enlarged schematic view of portion Q in FIG. 37. The adapter body 100 has an accommodation space (referring to FIG. 37). When the first cover 300 and the second cover 400 are buckled, the first rotatable member 500 drives the prongs 200 to retract to the accommodation space. When the first cover 300 and the second cover 400 are opened relatively, the first rotatable member 500 drives the prongs 200 to extend out of the accommodation space.

In FIG. 34, the first cover 300 and the second cover 400 are respectively fixed at two opposite sides of the adapter body 100 to expose the prongs 200. In FIG. 35, the first cover 300 and the second cover 400 are buckled and both located at one side of the adapter body 100.

In the implementation, the first rotatable member 500 further drives the prongs 200 to retract to or extend out of the accommodation space. When the first cover 300 and the second cover 400 are buckled, the prongs 200 further can retract to the accommodation space, which can make full use of the space of the adapter body 100, and the power adapter 10 with such structure can accommodate the prongs without using the first cover 300 and the second cover 400. In this way, the first cover 300 and the second cover 400 can be made relatively short, which is further conducive to the miniaturization of the power adapter 10.

In the implementation, the first rotatable member 500 includes a first rotatable sub-member 540, and the second rotatable member 600 includes a second rotatable sub-member 650. The first rotatable sub-member 540 and the second rotatable sub-member 650 are arranged in the adapter body 100 at intervals, and the first rotatable sub-member 540 and the second rotatable sub-member 650 are respectively connected to two opposite sides of the prong 200.

When the first cover 300 and the second cover 400 are buckled, the first rotatable sub-member 540 and the second rotatable sub-member 650 cooperate with each other to drive the prongs 200 to retract to the accommodation space. When the first cover 300 and the second cover 400 are opened relatively, the first rotatable sub-member 540 and the second rotatable sub-member 650 cooperate with each other to drive the prongs 200 to extend out of the accommodation space.

The specific structure of the first rotatable sub-member 540 of the disclosure will be described in detail below. The first rotatable sub-member 540 includes a transmission gear 541 and a rack 542. The transmission gear 541 is rotationally connected to the adapter body 100, the rack 542 is configured to fix the prong 200, and the rack 542 is driven to rotate by the transmission gear 541. There may be four transmission gears 541, which is not limited herein. The transmission gears 541 are disposed horizontally in sequence, and the rack 542 is vertically disposed in the adapter body 100. The rack 542 meshes with the transmission gear 541.

The second rotatable sub-member 650 also includes a transmission gear 651 and a rack 652. In the second rotatable sub-member 650, the transmission gear 651 is rotationally connected to the adapter body 100, the rack 652 is configured to fix the prong 200, and the rack 652 is driven to rotate by the transmission gear 651. There may be four transmission gears 651, which is not limited herein. The transmission gears 651 are disposed horizontally in sequence, and the rack 652 is vertically disposed in the adapter body 100. The rack 652 meshes with the transmission gear 651. The rack 652 of the second rotatable sub-member 650 and the rack 542 of the first rotatable sub-member 540 are respectively connected to two sides of the prong 200, the transmission gear 651 of the second rotatable sub-member 650 is away from the prong 200 compared with the rack 652 of the second rotatable sub-member 650. The structure of the transmission gear 651 of the second rotatable sub-member 650 is the same as the structure of the transmission gear 541 of the first rotatable sub-member 540, the structure of the rack 542 of the second rotatable sub-member 650 is the same as the structure of the rack 542 of the first rotatable sub-member 540, which is not repeated here. When the first cover 300 rotates relative to the adapter body 100, the transmission gear 541 and the transmission gear 651 rotate, then the rack 542 and the rack 652 are driven to move. The rack 542 and the rack 652 move, such that the prongs 200 retracts to or extends out of the accommodation space.

In the implementation, as an example, the prongs 200 are pulled out manually. In other implementations, the prongs 200 may also be driven to retract to or extend out of the accommodation space by electric means.

The implementations mentioned above are described with the example of the first rotatable member 500. It can be understood that, the structure of the second rotatable member 600 is the same as the structure of the first rotatable member 500, which is not repeated here.

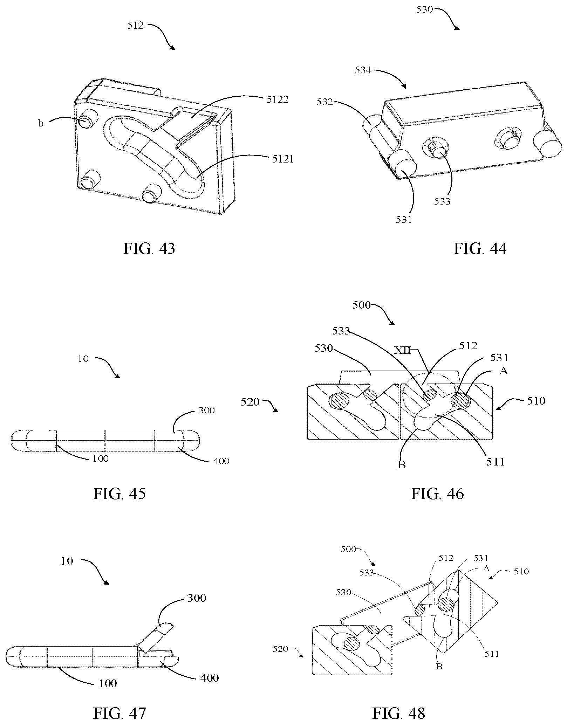

Referring to FIG. 39 to FIG. 44 together, FIG. 39 is an assembly view of a first rotatable member provided in an implementation of the disclosure, FIG. 40 is a schematic view illustrating a position of the first rotatable member in a power adapter, FIG. 41 is an exploded perspective view of a first rotatable member provided in an implementation of the disclosure, FIG. 42 is a schematic view of a first box in the first rotatable member provided in FIG. 39, FIG. 43 is a schematic view of a first box-cover in the first rotatable member provided in FIG. 39, and FIG. 44 is a schematic view of a first rotatable portion in the first rotatable member provided in FIG. 39. The power adapter 10 includes a first rotatable member 500 and a second rotatable member 600. One end of the first rotatable member 500 is connected to the first cover 300, and the other end of the first rotatable member 500 is connected to the adapter body 100, such that the first cover 300 is rotationally connected to the adapter body 100. One end of the second rotatable member 600 is connected to the second cover 400, and the other end of the second rotatable member 600 is connected to the adapter body 100, such that the second cover 400 is rotationally connected to the adapter body 100.

The first rotatable member 500 and the second rotatable member 600 are the same in structure and shape. In the following, the first rotatable member 500 is taken as an example for illustration. The first rotatable member 500 includes a first fixing portion 510, a second fixing portion 520, and a first rotatable portion 530. The first fixing portion 510 is fixed on the adapter body 100, the second fixing portion 520 is fixed on the first cover 300, and the first rotatable portion 530 is rotationally connected to the first fixing portion 510 and the second fixing portion520.

The first fixing portion 510 includes a first box 511 and a first box-cover 512, and the second fixing portion 520 includes a second box 521 and a second box-cover 522. The first box 511, the first box-cover 512, the second box 521, and the second box-cover 522 cooperatively define a receiving space, and the receiving space is used to accommodate the first rotatable portion 530. The first rotatable portion 530 is rotationally connected to the first box 511, the first box-cover 512, the second box 521, and the second box-cover 522. In the implementation, the rotational connection between the first cover 300 and the adapter body 100 can be realized only via the five components, i.e., the first box 511, the first box-cover 512, the second box 521, the second box-cover 522, and the first rotatable portion 530, and thus the structure is relatively simple. Therefore, when the first box 511, the first box-cover 512, the second box 521, the second box-cover 522, and the first rotatable portion 530 are assembled, the reliability of rotation and the assembly tolerance can be better controlled, the required materials and molds can be reduced, and the assembly cost can be reduced.

In the implementation, the first rotatable member 500 is made of polyamide reinforced with 60% glass fibers (PA+GF60). The elastic modulus of the material is up to 23 GPa, which is 10 times elastic modulus of ordinary plastic materials. The yield strength of the material reaches 235 Mpa, which is 5 times yield strength of ordinary materials. By using polyamide reinforced with 60% glass fibers (PA+GF60), the strength and stiffness of the shaft are greatly increased, thereby improving the reliability and service life of the first rotatable member 500.

The first box 511 is fixedly connected with the first box-cover 512, and the second box 521 is fixedly connected with the second box-cover 522. A manner in which the first box 511 is fixedly connected with the first box-cover 512 and a manner in which the second box 521 is fixedly connected with the second box-cover 522 will be described in detail later. The following will describe in detail, the structure of the first box 511, the first box-cover 512, and the first rotatable portion 530 required by the rotation of the first rotatable portion 530 relative to the first box 511 and the first box-cover 512. Additionally, the following will analyze and illustrate the rotation of the first rotatable portion 530 relative to the first box 511 and the first box-cover 512 in combination with the structure of the first box 511, the first box-cover 512, and the first rotatable portion 530.

The first box 511 includes a first mating portion 5111, and the first box-cover 512 includes a second mating portion 5121. Correspondingly, the first rotatable portion 530 includes a third mating portion 531 and a fourth mating portion 532. The third mating portion 531 cooperates with the first mating portion 5111, and the fourth mating portion 532 cooperates with the second mating portion 5121, such that the first rotatable portion 530 is rotatable relative to the first box 511 and the first box-cover 512. Specifically, in the implementation, the first mating portion 5111 and the second mating portion 5121 are both recesses, such as curved through holes. The third mating portion 531 and the fourth mating portion 532 are both protrusions, such as columns. The third mating portion 531 in the shape of a column is accommodated in the first mating portion 5111 in the shape of a through hole. The fourth mating portion 532 in the shape of a column is accommodated in the first mating portion 5111 in the shape of a through hole, and the columns are rotatable in the curved through holes. It can be understood that, in other implementations, the first mating portion 5111 may also be a curved groove, and the second mating portion 5121 may also be a curved groove. Alternatively, in other implementations, the first mating portion 5111 and the second mating portion 5121 are both protrusions, such as columns. The third mating portion 531 and the fourth mating portion 532 are both recesses, such as grooves or through holes.

Furthermore, in the implementation, the first box 511 includes a fifth mating portion 5112, the first box-cover 512 includes a sixth mating portion 5122, and correspondingly, the first rotatable portion 530 includes a seventh mating portion 533 and an eighth mating portion 534. The seventh mating portion 533 cooperates with the fifth mating portion 5112 and the eighth mating portion 534 cooperates with the sixth mating portion 5122, so as to relieve shaking of the first cover 300 when the first cover 300 is fixed relative to the adapter body 100 (the first cover 300 and the second cover 400 are buckled or fixed at two opposite sides of the adapter body 100), and improve smoothness of rotation of the first cover 300 relative to the adapter body 100.

In the implementation, the first mating portion 5111 is a curved through hole, and the second mating portion 5121 is a curved through hole. The fifth mating portion 5112 is a groove. The fifth mating portion 5112 in the shape of a groove communicates with the first mating portion 5111 in the shape of a through hole. The sixth mating portion 5122 is a groove. The sixth mating portion 5122 in the shape of a groove communicates with the second mating portion 5121 in the shape of a through hole. The cross section of the seventh mating portion 533 is elliptical, and the cross section of the eighth mating portion 534 is elliptical.

The first mating portion 5111 is a curved through hole, and the second mating portion 5121 is a curved through hole. The fifth mating portion 5112 is a groove, and the sixth mating portion 5122 is a groove. The fifth mating portion 5112 communicates with the first mating portion 5111, and the sixth mating portion 5122 communicates with the second mating portion 5121. The seventh mating portion 533 has an elliptical cross section, and the eighth mating portion 534 has an elliptical cross section. When the first cover 300 is fixed relative to the adapter body 100, a gap between the seventh mating portion 533 and the fifth mating portion 5112 is d1, and when the first cover 300 rotates relative to the adapter body 100, the gap between the seventh mating portion 533 and the fifth mating portion 5112 is d2, and d1<d2. When the first cover 300 is fixed relative to the adapter body 100, a gap between the eighth mating portion 534 and the sixth mating portion 5122 is d3, and when the first cover 300 rotates relative to the adapter body 100, the gap between the eighth mating portion 534 and the sixth mating portion 5122 is d4, and d3<d4. The above structural design of the first rotatable member 500 can relieve the shaking of the first cover 300 when the first cover 300 is fixed relative to the adapter body 100, and improve the smoothness of rotation of the first cover 300 relative to the adapter body 100.

When the first box 511, the first box-cover 512, the second box 521, the second box-cover 522, and the first rotatable portion 530 are connected, the first box 511 and the second box 521 are disposed diagonally, and the first box-cover 512 and the second box-cover 522 are disposed diagonally. The cooperation among the second box 521, the second box-cover 522, and the first rotatable portion 530 is the same as the cooperation among the first box 511, the second box-cover 522, and the first rotatable portion 530. The following will take the cooperation between the first rotatable portion 530 and the first box 511 and the cooperation between the first rotatable portion 530 and the first box-cover 512 as examples for illustration. The structure of the second box 521, the structure of the second box-cover 522, the cooperation between the second box 521 and the first rotatable portion 530, and the cooperation between the second box-cover 522 and the first rotatable portion 530 will not be illustrated.

Referring to FIG. 45 and FIG. 46 together, FIG. 45 is a schematic view of a power adapter in a state, and FIG. 46 is a sectional view of the first rotatable member illustrated in FIG. 39, taken along line XI-XI, when the power adapter is in the state illustrated in FIG. 45. In this case, the first cover 300 and the second cover 400 are buckled, and the first cover 300 and the second cover 400 are located at the same side of the end surface 110 of the adapter body 100 where the prongs 200 are connected. The first mating portion 5111 has a first end A and a second end B. When the first cover 300 and the second cover 400 are buckled, the first end A is away from the second box-cover 522 compared with the second end B. The second mating portion 5121 is located in the first mating portion 5111 and located at the first end A. The seventh mating portion 533 is located in the fifth mating portion 5112 and located at one end of the fifth mating portion 5112 close to the first mating portion 5111.

Referring to FIG. 47 and FIG. 48 together, FIG. 47 is a schematic view of a power adapter in another state, and FIG. 48 is a schematic view of a first rotatable member when the power adapter is in the state illustrated in FIG. 47. In the state, the first cover 300 and the second cover 400 of the power adapter 10 are opened relatively, and an angle between the first cover 300 and the second cover 400 opened relatively is an acute angle. The first mating portion 5111 is located in the second mating portion 5121 and close to the first end A, and the seventh mating portion 533 is located in the fifth mating portion 5112 and at the end of the fifth mating portion 5112 away from the first mating portion 5111.

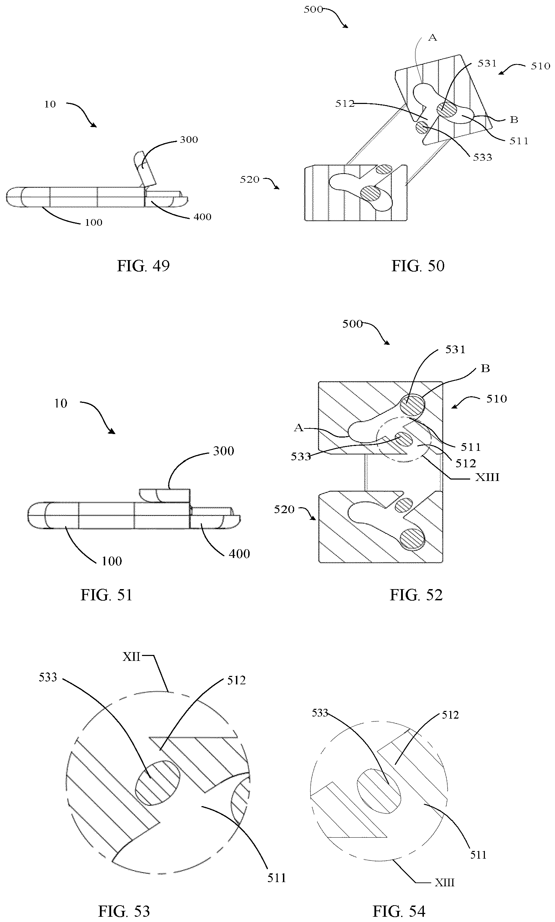

Referring to FIG. 49 and FIG. 50 together, FIG. 49 is a schematic view of a power adapter in another state, and FIG. 50 is a schematic view of the first rotatable member when the power adapter is in the state illustrated in FIG. 49. In the state, the first cover 300 and the second cover 400 of the power adapter 10 are opened relatively, and an angle between the first cover 300 and the second cover 400 opened relatively is an obtuse angle. The first mating portion 5111 is located in the second mating portion 5121 and close to the second end B, and the seventh mating portion 533 is located in the fifth mating portion 5112 and at the end of the fifth mating portion 5112 away from the first mating portion 5111.

Referring to FIG. 51 and FIG. 52 together, FIG. 51 is a schematic view of a power adapter in another state, and FIG. 52 is a schematic view of the first rotatable member when the power adapter is in the state illustrated in FIG. 51. In the state, the first cover 300 and the second cover 400 of the power adapter 10 are opened relatively and buckled at the two opposite sides of the adapter body 100. The first mating portion 5111 is located in the second mating portion 5121 and located at the second end B, and the seventh mating portion 533 is located in the fifth mating portion 5112.

The cross section of the seventh mating portion 533 is elliptical. When the first cover 300 and the second cover 400 are buckled, the big end (the major axis of the ellipse) of the seventh mating portion 533 cooperates with the fifth mating portion 5112, the gap between the seventh mating portion 533 and the fifth mating portion 5112 is relatively small (as illustrated in FIG. 53, FIG. 53 is an enlarged schematic view of portion XII in FIG. 46), and the shaking of the first rotatable portion 500 is relatively small. As the first cover 300 is gradually opened, it gradually becomes that the small end (the minor axis of the ellipse) of the seventh mating portion 533 cooperates with the fifth mating portion 5112. In this case, the gap between the seventh mating portion 533 and the fifth mating portion 5112 is relatively large (as illustrated in FIG. 54, and FIG. 54 is an enlarged schematic view of portion XIII in FIG. 52), such that the first rotatable member 500 can rotate more smoothly. It can be seen that the first rotatable member 500 in the disclosure can achieve the balance between smooth rotation and no shaking between the first cover 300 and the adapter body 100.

Referring further to FIG. 42 and FIG. 43, the first box 511 is fixedly connected with the first box-cover 512. Specifically, the first box 511 includes a mating portion *a*, the first box-cover 512 includes a mating portion *b,* and the mating portion *a* cooperates with the mating portion *b* to fix the first box 511 with the first box-cover 512. In the implementation, the mating portion *a* is a recess, such as a cylindrical groove, and the mating portion *b* is protrusion, such as a column. When assembling, the column on the first box-cover 512 is accommodated in the cylindrical groove defined in the first box 511, and is in interference fit with the groove. In other implementations, the mating portion *a* may be a protrusion, and correspondingly, the mating portion b may be a recess.

The second box 521 is fixedly connected with the second box-cover 522. A manner in which the second box 521 is fixedly connected with the second box-cover 522 is the same as the manner in which the first box 511 is fixedly connected with the second box-cover 522, which is not repeated herein.

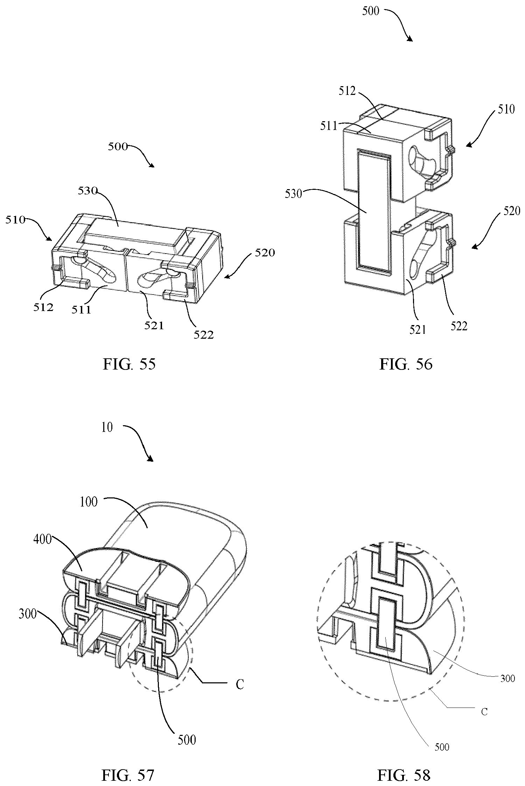

Referring to FIG. 55 to FIG. 58, FIG. 55 is an assembly view of a first rotatable member provided in yet another implementation of the disclosure, viewed from an angle, FIG. 56 is an assembly view of the first rotatable member provided in FIG. 55, viewed from another angle, FIG. 57 is a schematic view illustrating the first rotatable member provided in FIG. 56 being applied to a power adapter, and FIG. 58 is an enlarged schematic view of portion C in FIG. 57. The structure of the first rotatable member 500 in the implementation is similar to the structure of the first rotatable member 500 provided in FIG. 39 and related implementations of FIG. 39. The first rotatable member 500 includes a first fixing portion 510, a second fixing portion 520, and a first rotatable portion 530. The first fixing portion 510 is fixed on the adapter body 100, the second fixing portion 520 is fixed on the first cover 300, and the first rotatable portion 530 is rotationally connected to the first fixing portion 510 and the second fixing portion 520.

The cooperation between the first fixing portion 510 and the first rotatable portion 530 in the implementation is exactly the same as the cooperation between the first fixing portion 510 and the first rotatable member 500 illustrated in FIG. 39 and the related implementations of FIG. 39. The cooperation between the second fixing portion 520 and the first rotatable portion 530 in the implementation is exactly the same as the cooperation between the second fixing portion 520 and the first rotatable member 500 illustrated in FIG. 39 and the related implementations of FIG. 39. The difference is described in detail as follows. In the implementation, the first fixing portion 510 includes a first box 511 and a first box-cover 512, and the second fixing portion 520 includes a second box 521 and a second box-cover 522. The first box-cover 512, the first box 511, the second box 521, and the second box-cover 522 are disposed in sequence (for example, from left to right) to define a receiving space. The receiving space is used to accommodate the first rotatable portion 530. The first box-cover 512 and the first box 511 cooperatively form the first mating portion 5111, and the first box 511 and the first box-cover 512 cooperatively form the second mating portion 5121. The second box 521 and the first box 511 are symmetrical with respect to a symmetry axis, and the second box-cover 522 and the first box-cover 512 are symmetrical with respect to a symmetry axis.

When the first rotatable member 500 in the implementation is connected with the first cover 300 and the adapter body 100, the gap between the adapter body 100 and a part of the first rotatable member 500 exposed outside the adapter body 100 (as illustrated in FIG. 57 and FIG. 58) can be reduced, which can reduce the probability of dust, water vapor, etc. entering the adapter body 100 through the gap, and make the adapter body 100 look more beautiful at a position where the first rotatable member 500 is disposed.

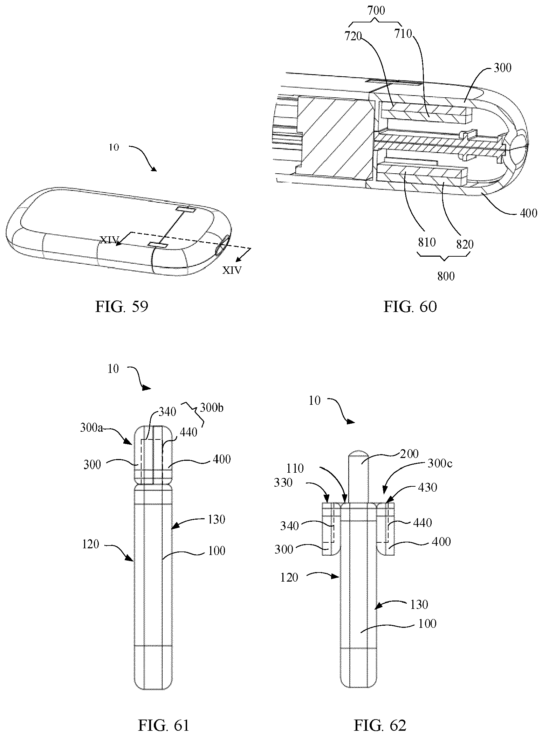

In combination with the power adapter 10 described in any implementation mentioned above, referring to FIG. 59 and FIG. 60, FIG. 59 is a perspective schematic structural view of a power adapter provided in another implementation of the disclosure, and FIG. 60 is a sectional view of the power adapter illustrated in FIG. 59, taken along line XIV-XIV. The power adapter 10 further includes a first magnetic member 700 and a second magnetic member 800. The first magnetic member 700 is carried on the first cover 300, and the second magnetic member 800 is carried on the second cover 400. The first magnetic member 700 and the second magnetic member 800 are attracted to each other when the first cover 300 and the second cover 400 are buckled. The first magnetic member 700 and the second magnetic member 800 are attracted to each other when the first cover 300 and the second cover 400 are opened relatively, such that the first cover 300 and the second cover 400 are fixed respectively at two opposite sides of the adapter body 100.

The first magnetic member 700 includes a first magnetic pole 710 and a second magnetic pole 720 which are arranged opposite each other and have opposite polarities, and the second magnetic member 800 includes a third magnetic pole 810 and a fourth magnetic pole 820 which are arranged opposite each other and have opposite polarities. The first magnetic pole 710 and the third magnetic pole 810 are attracted to each other when the first cover 300 and the second cover 400 are buckled, and the second magnetic pole 720 and the fourth magnetic pole 820 are attracted to each other when the first cover 300 and the second cover 400 are opened relatively.

In the implementation, the first magnetic pole 710 is a south pole, and the second magnetic pole 720 is a north pole. Correspondingly, the third magnetic pole 810 is a north pole, and the fourth magnetic pole 820 is a south pole. In other implementations, the first magnetic pole 710 is a north pole, and the second magnetic pole 720 is a south pole. Correspondingly, the third magnetic pole 810 is a south pole, and the fourth magnetic pole 820 is a north pole.

When the first cover 300 and the second cover 400 are buckled, the first magnetic pole 710 and the third magnetic pole 810 are attracted to each other, such that the first cover 300 and the second cover 400 maintains the state of being buckled. When one of the first cover 300 and the second cover 400 is opened, for example, when the first cover 300 is opened and the second cover 400 is not opened, the magnetism direction of the first magnetic member 700 in the first cover 300 opened is changed. As a result, the second magnetic pole 720 and the third magnetic pole 810 repel each other, such that the second cover 400 is subject to a repulsive force for flipping, and the second cover 400 is flipped under the effect of the repulsive force. Therefore, the second cover 400 can flip automatically without being operated. When the second cover 400 flips to a certain extent, the second magnetic pole 720 and the fourth magnetic pole 820 are attracted to each other, such that the first cover 300 and the second cover 400 are fixed at the two opposite sides of the adapter body 100.

When the first cover 300 and the second cover 400 are opened relatively and respectively fixed at the two opposite sides of the adapter body 100, the second magnetic pole 720 and the fourth magnetic pole 820 are attracted to each other, such that the first cover 300 and the second cover 400 are opened relatively and maintain the state of respectively being fixed at the two opposite sides of the adapter body 100. In this case, the first cover 300 is folded relative to the adapter body 100, and the second cover 400 is folded relative to the adapter body 100. When the first cover 300 is expanded relative to the adapter body 100, the magnetism direction of the first magnetic member 700 is changed. As a result, the first magnetic pole 710 and the fourth magnetic pole 820 repel each other, such that the second cover 400 in a folded state is subject to a flipping force for flipping relative to the adapter body 100, and the second cover 400 flips under the effect of the flipping force. When the second cover 400 flips to a certain extent, the first magnetic pole 710 and the third magnetic pole 810 are attracted to each other, such that the first cover 300 and the second cover 400 form a cover and are fixed at one side of the adapter body 100.

Referring to FIG. 61 and FIG. 62, FIG. 61 is a schematic view of a power adapter in a state provided in an implementation of the disclosure, and FIG. 62 is a schematic view of a power adapter in another state provided in an implementation of the disclosure. The power adapter 10 includes an adapter body 100, prongs 200, a first cover 300, and a second cover 400. The prongs 200 are connected to the adapter body 100, and the first cover 300 and the second cover 400 are both rotationally connected to the adapter body 100. When the first cover 300 is expanded relative to the adapter body 100, the outer surface of the first cover 300 is coplanar with part of the outer surface of the adapter body 100. When the first cover 300 is folded relative to the adapter body 100, the first cover 300 is stacked on the adapter body 100. When the second cover 400 is expanded relative to the adapter body 100, the outer surface of the first cover 300 is coplanar with part of the outer surface of the adapter body 100. When the second cover 400 is folded relative to the adapter body 100, the second cover 400 is stacked on the adapter body 100. When the first cover 300 and the second cover 400 are expanded relative to the adapter body 100, the prongs 200 are covered. When the first cover 300 and the second cover 400 are folded relative to the adapter body 100, the prongs 200 are exposed.

The end surface 110 of the adapter body 100 where the prongs 200 are exposed is named a first end-surface, the surface 330 of the first cover 300 facing the prongs 200 is named a second end-surface, and the surface 430 of the second cover 400 facing the prongs 200 is named a third end-surface. When the first cover 300 and the second cover 400 are buckled, the first cover 300 and the second cover 400 are located at the same side of the first end-surface to cover the prongs 200, and the second end-surface and the third end-surface both face the first end-surface. When the first cover 300 and the second cover 400 are opened relatively, the first cover 300 and the second cover 400 are respectively stacked on two opposite sides of the adapter body 100 to expose the prongs 200, and the first end-surface, the second end-surface, and the third end-surface cooperatively form the plug surface of the power adapter 10.

Compared with the traditional technology, in the power adapter 10 provided herein, when the first cover 300 and the second cover 400 are buckled, the prongs 200 are covered, and thus the prongs 200 can be protected from being damaged and other objects can be prevented from being damaged by the prongs 200. When the power adapter 10 is used, the first cover 300 and the second cover 400 are respectively folded relative to the adapter body 100 to expose the prongs 200. Furthermore, the first end-surface, the second end-surface, and the third end-surface cooperatively form the plug surface of the power adapter 10. In other words, the end surface of the adapter body 100 only forms part of the plug surface of the power adapter 10 and the adapter body 100 can be made relatively thin, which is conductive to the miniaturization of the power adapter 10.

Specifically, the adapter body 100 includes a first side surface 120 and a second side surface 130 opposite the first side surface 120. The first cover 300 includes a first surface 310, and the second cover 400 includes a second surface 410. When the first cover 300 is expanded relative to the adapter body 100, the first surface 310 is coplanar with the first side surface 120. When the first cover 300 is folded relative to the adapter body 100, the first surface 310 faces the first side surface 120. When the second cover 400 is expanded relative to the adapter body 100, the second surface 410 is coplanar with the second side surface 130. When the second cover 400 is folded relative to the adapter body 100, the second surface 410 faces the second side surface 130.

The first surface 310 faces the first side surface 120 as follows. The first surface 310 is directly attached to the first side surface 120, there is a gap between the first surface 310 and the first side surface 120, or the first surface 310 is indirectly attached to the first side surface 120 via the first flexible membrane. Similarly, the second surface 410 faces the second side surface 130 as follows. The second surface 410 is directly attached to the second side surface 130, there is a gap between the second surface 410 and the second side surface 130, or the second surface 410 is indirectly attached to the second side surface 130 via the second flexible membrane.

Specifically, the power adapter 10 further includes the first rotatable member 500 and the second rotatable member 600. One end of the first rotatable member 500 is connected with the first cover 300, and the other end of the first rotatable member 500 is connected with the adapter body 100, such that the first cover 300 is rotationally connected to the adapter body 100. One end of the second rotatable member 600 is connected with the second cover 400, and the other end of the second rotatable member 600 is connected to the adapter body 100, such that the second cover 400 is rotationally connected to the adapter body 100. The first rotatable member 500 and the second rotatable member 600 have many forms which are described in detail as follows.

The first rotatable member 500 is the first flexible membrane, and the second rotatable member 600 is the second flexible membrane. The first flexible membrane is attached to the first side surface 120 and the first surface 310, such that the first cover 300 is rotationally connected to the adapter body 100. The second flexible membrane is attached to the second side surface 130 and the second surface 410, such that the second cover 400 is rotationally connected to the adapter body 100.

The first rotatable member 500 and the second rotatable member 600 may also have other forms, reference can be made to the illustration mentioned above, which will not be repeated herein.

In combination with the power adapter 10 provided in any implementation mentioned above, a thickness D1 of the adapter body 100 of the power adapter 10 fulfills 6.3 mm≤D1≤14 mm.

It should be noted that, the thickness of the adapter body 100 refers to the maximum size of the adapter body 100 along the thickness direction.

According to the requirements of safety regulations, for the power adapter 100 applicable to China, the width of the prong 200 is usually 6.3 mm. Therefore, D1≥6.3 mm. In order to make the power adapter 10 relatively thin, the thickness D 1 of the adapter body 100 fulfills D1≤14 mm.

In an implementation, the thickness D1 of the adapter body 100 fulfills 9.65 mm≤D1≤14 mm, a thickness D2 of the first cover 300 fulfills 4.825 mm≤D2≤7 mm, and a thickness D3 of the second cover 400 fulfills 4.825 mm≤D3≤7 mm.

In an implementation, the thickness D2 of the first cover 300 is equal to the thickness D3 of the second cover 400, and the sum of the thickness D2 of the first cover 300 and the thickness D3 of the second cover 400 is equal to the thickness D1 of the adapter body 100.

The above sizes are not randomly selected, but are designed in combination with the requirements of safety regulations of the power adapter 10. Specifically, when the first cover 300 and the second cover 400 are relatively opened, according to the safety regulations, it is required that the distance from the side surface of the prong 200 close to the first cover 300 to the outermost side of the first cover 300 needs to be greater than or equal to 6.5 mm, such that the current is prevented from leaking out to harm users when the power adapter 10 is plugged into the socket 50 via the prongs 200. Similarly, according to the safety regulations, it is required that the distance from the side surface of the prong 200 close to the second cover 400 to the outermost side of the second cover 400 needs to be greater than or equal to 6.5 mm. Additionally, according to the requirements of the safety regulations, the width of the prong 200 is 6.3 mm. Therefore, the minimum value of the sum of the thickness D1 of the adapter body 100, the thickness D2 of the first cover 300, and the thickness D3 of the second cover 400 is 19.3 mm (D1+D2+D3=6.3 mm+6.6 mm+6.5 mm). In this case, when the sum of the thickness D2 of the first cover 300 and the thickness D3 of the second cover 400 is equal to the thickness D1 of the adapter body 100, the minimum value of the thickness D1 of the adapter body 100 is 9.65 mm (19.3 mm/2). When the thickness of the first cover 300 is equal to the thickness of the second cover 400, D2 is 4.825 mm (9.65 mm/2), D3 is 4.825 mm (9.65 mm/2), i.e., the minimum value of the thickness of the first cover 300 is 4.825 mm, and the minimum value of the thickness of the second cover 400 is 4.825 mm. Since the thickness of the adapter body of the traditional power adapter is generally greater than 14 mm, in order to make the adapter body 100 in the power adapter 10 described in the disclosure relatively thin, the upper limit value of the thickness of the adapter body 100 can be selected as 14 mm. When the thickness of the first cover 300 is equal to the thickness of the second cover 400, and the sum of the thickness of the first cover 300 and the thickness of the second cover 400 is equal to the thickness of the adapter body 100, the upper limit value of the thickness of the first cover 300 is 7 mm, and the upper limit value of the thickness of the second cover 300 is 7 mm.

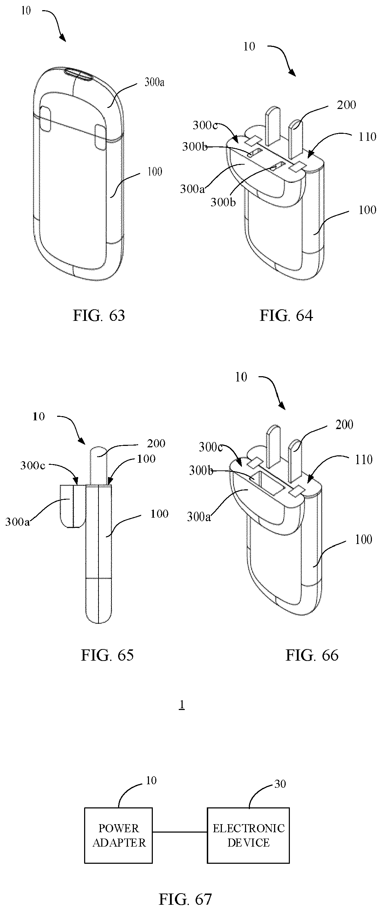

Referring to FIG. 63 to FIG. 65, FIG. 63 is a perspective schematic view of a power adapter in a state provided in another implementation of the disclosure, FIG. 64 is a perspective schematic view of the power adapter provided in FIG. 63 in another state in an implementation, and FIG. 65 is a side view of the power adapter illustrated in FIG. 64 in an implementation. In the implementation, FIG. 63 is a schematic view illustrating the cover 300a in a closed state, and FIG. 64 is a schematic view illustrating the cover 300a in an open state. In the implementation, there is one cover 300a. When the cover 300a is opened, the cover 300a is located at one side of the adapter body 100, and a surface 300c of the cover 300a facing the prongs 200 and the end surface 110 of the adapter body 100 cooperatively form the plug surface of the power adapter 10.

In the implementation, the cover 300a is rotationally connected to the adapter body 100. When the cover 300a is closed, the prongs 200 can be protected from being damaged and other objects can be prevented from being damaged by the prongs 200. When the power adapter 10 is used, the cover 300a is opened relatively to expose the prongs 200. The surface 300c of the cover 300a facing the prongs 200 and the end surface 110 of the adapter body 100 cooperatively form the plug surface of the power adapter 10. In other words, the end surface of the adapter body 100 only forms part of the plug surface of the power adapter 10 and the adapter body 100 can be made relatively thin, which is conductive to the miniaturization of the power adapter 10.

In the implementation, the cover 300a defines two accommodation cavities 300b spaced from each other on the surface 300c of the cover 300a facing the prongs 100. Each of the accommodation cavities 300b is used to accommodate one prong 200.

Referring to FIG. 63, FIG. 65, and FIG. 66 together, FIG. 66 is a perspective schematic view of the power adapter provided in FIG. 63 in another state in an implementation. The implementation is substantially the same as FG. 64 and related illustration of FIG. 64, the similarities will not be repeated, and the differences are as follows. In the implementation, the cover 300a defines one accommodation cavity 300b on the surface 300c of the cover 300a facing the prongs 100, and the accommodation cavity 300b is used to accommodate all the prongs 200 of the power adapter 100.

Referring to FIG. 67, FIG. 67 is a schematic diagram of an electronic device assembly provided in an implementation of the disclosure. The electronic device assembly 1 includes an electronic device 30 and a power adapter 10. The power adapter 10 is configured to charge the electronic device 30. The electronic device 30 may be a device which needs to be charged, such as a mobile phone and a computer. The electronic device 30 includes a battery. The power adapter 10 is configured to receive a first voltage and convert the first voltage into a second voltage, and the second voltage is used to charge the battery. For the illustration of the power adapter 10, reference can be made to the illustration mentioned above, which will not be repeated here.

Although the implementations of the disclosure have been illustrated and described above, it can be understood that the above implementations are exemplary and cannot be understood as limitation on the disclosure. Those skilled in the art can change, modify, replace and transform the above implementations within the scope of the disclosure, and these improvements and embellishments are also considered to be within the protection scope of the disclosure.

## Claims

1. A power adapter, comprising:
an adapter body;
prongs, the prongs being exposed at an end surface of the adapter body; and
a cover connected to the adapter body, rotatable relative to the adapter body, and having an accommodation cavity corresponding to the prongs, wherein when the cover is closed, the accommodation cavity of the cover accommodates the prongs, and when the cover is opened, a surface of the cover facing the prongs and the end surface of the adapter body cooperatively form a plug surface of the power adapter.

2. The power adapter of claim 1, wherein the cover comprises a first cover and a second cover, the first cover is connected to the adapter body and rotatable relative to the adapter body, the second cover is connected to the adapter body and rotatable relative to the adapter body, and when the first cover and the second cover are buckled, the first cover and the second cover cooperatively cover the prongs; when the first cover and the second cover are opened relatively, the prongs are exposed, and a surface of the first cover facing the prongs, a surface of the second cover facing the prongs, and the end surface of the adapter body cooperatively form the plug surface of the power adapter.

3. The power adapter of claim 2, wherein the power adapter further comprises a first rotatable member and a second rotatable member, one end of the first rotatable member is connected to the first cover, and the other end of the first rotatable member is connected to the adapter body, such that the first cover is rotationally connected to the adapter body; and one end of the second rotatable member is connected to the second cover, and the other end of the second rotatable member is connected to the adapter body, such that the second cover is rotationally connected to the adapter body.

4. The power adapter of claim 3, wherein the first rotatable member is a first flexible membrane, and the first flexible membrane is attached to an outer surface of the adapter body and an outer surface of the first cover; and the second rotatable member is a second flexible membrane, and the second flexible membrane is attached to the outer surface of the adapter body and an outer surface of the second cover.

5. The power adapter of claim 4, wherein the outer surface of the adapter body comprises a first side surface and a second side surface opposite the first side surface, the first side surface defines a first groove, the first cover defines a second groove on the outer surface of the first cover, and the second groove communicates with the first groove to define a whole space to accommodate the first flexible membrane.

6. The power adapter of claim 4, wherein the first flexible membrane is made of an insulative material, and the first flexible membrane further covers a gap between the first cover and the adapter body; and the second flexible membrane is made of an insulative material, and the second flexible membrane further covers a gap between the second cover and the adapter body.

7. The power adapter of claim 3, wherein the first rotatable member comprises a first fixing portion, a second fixing portion, and a first rotatable portion, the first fixing portion is fixed on the adapter body, the second fixing portion is fixed on the first cover, and the first rotatable portion is rotationally connected to the first fixing portion and the second fixing portion; and the second rotatable member comprises a third fixing portion, a fourth fixing portion, and a second rotatable portion, the third fixing portion is fixed on the adapter body, the fourth fixing portion is fixed on the second cover, and the second rotatable portion is rotationally connected to the third fixing portion and the fourth fixing portion.

8. The power adapter of claim 7, wherein the adapter body comprises a housing and a prong base, the housing has an opening, the prong base is configured to fix the prongs, is fixed on the housing, and seals the opening, and the first fixing portion and the third fixing portion are respectively fixed on the prong base.

9. The power adapter of claim 3, wherein the adapter body has an accommodation space, and when the first cover and the second cover are buckled, the first rotatable member is further configured to drive the prongs to retract to the accommodation space; and when the first cover and the second cover are opened relatively, the first rotatable member is further configured to drive the prongs to extend out of the accommodation space.

10. The power adapter of claim 9, wherein the first rotatable member comprises a first rotatable sub-member, the second rotatable member comprises a second rotatable sub-member, the first rotatable sub-member and the second rotatable sub-member are arranged in the adapter body at intervals, the first rotatable sub-member and the second rotatable sub-member are respectively connected to two opposite sides of the prongs, and when the first cover and the second cover are buckled, the first rotatable sub-member and the second rotatable sub-member cooperate with each other to drive the prongs to retract to the accommodation space; and when the first cover and the second cover are opened relatively, the first rotatable sub-member and the second transmission sub-member cooperate with each other to drive the prongs to extend out of the accommodation space.

11. The power adapter of claim 10, wherein the first rotatable sub-member comprises a transmission gear and a rack, the second rotatable sub-member comprises a transmission gear and a rack, the transmission gear of the first rotatable sub-member and the transmission gear of the second rotatable sub-member are rotationally connected to the adapter body, the rack of the first rotatable sub-member and the rack of the second rotatable sub-member are configured to fix the prongs; and the rack of the first rotatable sub-member is driven to rotate by the gear of the first rotatable sub-member, and the rack of the second rotatable sub-member is driven to rotate by the gear of the second rotatable sub-member, such that the prongs are driven to retract to or extend out of the accommodation space.

12. The power adapter of claim 7, wherein the first fixing portion comprises a first box and a first box-cover, the second fixing portion comprises a second box and a second box-cover, the first box, the first box-cover, the second box, and the second box-cover cooperatively define a receiving space, the receiving space is used to accommodate the first rotatable portion, and the first rotatable portion is rotationally connected to the first box, the first box-cover, the second box, and the second box-cover.

13. The power adapter of claim 12, wherein the first box comprises a first mating portion, the first box-cover comprises a second mating portion, the first rotatable portion comprises a third mating portion and a fourth mating portion, the third mating portion cooperates with the first mating portion and the fourth mating portion cooperates with the second mating portion, such that the first rotatable portion is rotatable relative to the first box and the first box-cover.

14. The power adapter of claim 13, wherein the first box further comprises a fifth mating portion, the first box-cover further comprises a sixth mating portion, the first rotatable portion comprises a seventh mating portion and an eighth mating portion, the seventh mating portion cooperates with the fifth mating portion and the eighth mating portion cooperates with the sixth mating portion, so as to relieve shaking of the first cover when the first cover is fixed relative to the adapter body and improve smoothness of rotation of the first cover relative to the adapter body.

15. The power adapter of claim 14, wherein the first mating portion is a curved through hole, the second mating portion is a curved through hole, the fifth mating portion is a groove, the sixth mating portion is a groove, the fifth mating portion communicates with the first mating portion, the sixth mating portion communicates with the second mating portion, the seventh mating portion has an elliptical cross section, and the eighth mating portion has an elliptical cross section; when the first cover is fixed relative to the adapter body, a gap between the seventh mating portion and the fifth mating portion is d1, when the first cover rotates relative to the adapter body, the gap between the seventh mating portion and the fifth mating portion is d2, and d1<d2; and when the first cover is fixed relative to the adapter body, a gap between the eighth mating portion and the sixth mating portion is d3, when the first cover rotates relative to the adapter body, the gap between the eighth mating portion and the sixth mating portion is d4, and d3<d4.

16. The power adapter of any one of claims 2 to 15, further comprising a first magnetic member and a second magnetic member, wherein the first magnetic member is carried on the first cover, and the second magnetic member is carried on the second cover; and the first magnetic member and the second magnetic member are attracted to each other when the first cover and the second cover are buckled, and the first magnetic member and the second magnetic member are attracted to each other when the first cover and the second cover are opened relatively, such that the first cover and the second cover are fixed respectively at two opposite sides of the adapter body.

17. The power adapter of claim 16, wherein the first magnetic member comprises a first magnetic pole and a second magnetic pole which are arranged opposite each other and have opposite polarities, the second magnetic member comprises a third magnetic pole and a fourth magnetic pole which are arranged opposite each other and have opposite polarities, the first magnetic pole and the third magnetic pole are attracted to each other when the first cover and the second cover are buckled, and the second magnetic pole and the fourth magnetic pole are attracted to each other when the first cover and the second cover are opened relatively.

18. The power adapter of claim 2, wherein a thickness D1 of the adapter body fulfills 6.3 mm≤D1≤14 mm.

19. The power adapter of claim 18, wherein a thickness D2 of the first cover fulfills 4.825 mm≤D2≤ 7mm, and a thickness D3 of the second cover fulfills 4.825 mm≤D3≤7 mm.

20. The power adapter of claim 1, wherein the number of the cover is one, when the cover is opened, the cover is located at one side of the adapter body, and the surface of the cover facing the prongs and the end surface of the adapter body cooperatively form the plug surface of the power adapter.

21. A power adapter, comprising an adapter body, prongs, a first cover, and a second cover, the adapter body having a first end-surface where the prongs are exposed, the first cover having a second-end surface, the second cover having a third end-surface, and the first cover and the second cover being both rotationally connected to the adapter body, wherein when the first cover and the second cover are buckled, the first cover and the second cover are located at the same side of the first end-surface to cover the prongs, and the second end-surface and the third end-surface face the first end-surface; and when the first cover and the second cover are opened relatively, the first cover and the second cover are stacked respectively on two opposite sides of the adapter body to expose the prongs, and the first end-surface, the second end-surface, and the third end-surface cooperatively form a plug surface of the power adapter.

22. The power adapter of claim 21, wherein the adapter body has a first side surface and a second side surface opposite the first side surface, the first cover has a first surface, and the second cover has a second surface; when the first cover and the second cover are buckled, the first surface is coplanar with the first side surface, and the second surface is coplanar with the second side surface; and when the first cover and the second cover are opened relatively, the first surface faces the first side surface, and the second surface faces the second side surface.

23. The power adapter of claim 22, wherein the power adapter further comprises a first flexible membrane and a second flexible membrane, the first flexible membrane is attached to the first side surface and the first surface, such that the first cover is rotationally connected to the adapter body, and the second flexible membrane is attached to the second side surface and the second surface, such that the second cover is rotationally connected to the adapter body.

24. The power adapter of claim 21, wherein the power adapter further comprises a first rotatable member and a second rotatable member, the first rotatable member comprises a first fixing portion, a second fixing portion, and a first rotatable portion, the first fixing portion is fixed on the adapter body, the second fixing portion is fixed on the first cover, and the first rotatable portion is rotationally connected to the first fixing portion and the second fixing portion; and the second rotatable member comprises a third fixing portion, a fourth fixing portion, and a second rotatable portion, the third fixing portion is fixed on the adapter body, the fourth fixing portion is fixed on the second cover, and the second rotatable portion is rotationally connected to the third fixing portion and the fourth fixing portion.

25. The power adapter of claim 21, wherein the adapter body has an accommodation space, the power adapter further comprises a first transmission member and a second transmission member, when the first cover and the second cover are both folded relative to the adapter body, the first transmission member and the second transmission member cooperate with each other to drive the prongs to extend out of the accommodation space, and when the first cover and the second cover are both expanded relative to the adapter body, the first transmission member and the second transmission member cooperate with each other to drive the prongs to retract to the accommodation space.

26. The power adapter of claim 24, wherein the first fixing portion comprises a first box and a first box-cover, the second fixing portion comprises a second box and a second box-cover, the first box, the first box-cover, the second box, and the second box-cover cooperatively define a receiving space, the receiving space is used to accommodate the first rotatable portion, and the first rotatable portion is rotationally connected to the first box, the first box-cover, the second box, and the second box-cover.

27. The power adapter of any one of claims 21 to 26, further comprising a first magnetic member and a second magnetic member, wherein the first magnetic member is disposed in the first cover, the second magnetic member is disposed in the second cover; the first magnetic member and the second magnetic member are attracted to each other when the first cover and the second cover are both expanded relative to the adapter body, the first magnetic member and the second magnetic member are attracted to each other when the first cover and the second cover are both folded relative to the adapter body, such that the first cover and the second cover are fixed respectively at two opposite sides of the adapter body.

28. The power adapter of claim 21, wherein a thickness D1 of the adapter body fulfills 6.3 mm≤D1≤14 mm, a thickness D2 of the first cover fulfills 4.825 mm≤D2≤7 mm, and a thickness D3 of the second cover fulfills 4.825 mm≤D3≤7 mm.

29. A power adapter, comprising an adapter body, prongs, a first cover, and a second cover, the prongs being connected to the adapter body, the first cover and the second cover being both rotationally connected to the adapter body, the first cover and the second cover cooperating with each other to cover or expose the prongs, a thickness D1 of the adapter body fulfilling 6.3 mm≤D1≤14 mm, and an end surface of the adapter body where the prongs are exposed forming part of a plug surface where the power adapter is plugged into a socket.

30. The power adapter of claim 29, wherein part of an end surface of the first cover and part of an end surface of the second cover further form part of the plug surface, and a width D of the plug surface fulfills 19.3 mm≤D≤28 mm.

31. The power adapter of claim 30, wherein the first cover and the second cover are stacked respectively on two opposite sides of the adapter body, a thickness D2 of the first cover fulfills 4.825 mm≤D2≤7 mm, a thickness D3 of the second cover fulfills 4.825 mm≤d3≤7 mm, and the adapter body, the first cover, and the second cover cooperatively form the plug surface.

32. An electronic device assembly, comprising an electronic device and the power adapter of any one of claims 1 to 31, the power adapter being configured to charge the electronic device.
